# EUROPEAN PATENT SPECIFICATION

(11) **EP 3 652 618 B1**
(45) Date of publication and mention of the grant of the patent: **01.09.2021**
(21) Application number: 18755854.9
(22) Date of filing: 12.07.2018
(51) Int. Cl.: G06F 3/01

(54) **ACTIVE ELEMENT STRUCTURE**
AKTIVE ELEMENTSTRUKTUR
STRUCTURE D'ÉLÉMENT ACTIF

(30) Priority: 14.07.2017 FI 20175691
(43) Date of publication of application: 20.05.2020
(73) Proprietor: PixArt Imaging Inc., Hsin-Chu City 300 (TW)
(72) Inventor: MÄKINEN, Ville, 02600 Espoo (FI); TEJERA-GARCIA, Roberto, 02600 Espoo (FI); SALMINEN, Aki, 02600 Espoo (FI)
(74) Representative: Straus, Alexander
(86) International application number: PCT/FI2018/050543
(87) International publication number: WO 2018/172622

(56) References cited:
- JP-A- H0 628 750
- JP-A- H08 168 099
- JP-B2- 5 674 222
- KR-A- 20150 112 793
- US-A1- 2012 306 790
- US-A1- 2013 075 237

## Description

### TECHNICAL FIELD

The subject matter disclosed herein generally relates to an arrangement for facilitating a surface actuation mechanism in devices (e.g., systems or other apparatus) with a surface structure configured to facilitate electrically induced mechanical movement, including devices configured to provide, via electrically induced mechanical movement, various tactile effects such as tactile feedback. Specifically, the present disclosure addresses an active element structure for devices (e.g., systems or other apparatus) that have a surface structure configured to facilitate electrically induced mechanical movement.

### BACKGROUND

There are different techniques facilitating electrically induced mechanical movement in devices, such as e.g. consumer electronic devices. One common technique is the use of an Eccentric Rotating Mass (ERM) vibration motor. An ERM vibration motor moves small rotating mass that is off-center from the point of rotation. The rotation of the mass produces a centripetal force causing the entire motor to move and vibrate from side to side. Another common technique facilitating electrically induced mechanical movement is the use of a linear resonant actuator (LRA). A linear resonant actuator uses magnetic fields and electrical current to create a force to a coil, said coil driving a magnetic mass up and down against a spring. The movement of said magnetic mass moves the entire linear resonant actuator, thus producing electrically induced mechanical movement. Another common technique is the use of a piezoelectric actuator. A piezoelectric actuator produces a mechanical change in the piezoelectric material in response to an applied electric charge, said mechanical change producing electrically induced mechanical movement.

In prior art, such electrically induced mechanical movement techniques have many disadvantages. These disadvantages include high power consumption, low durability, a shorter lifespan, complex design with external motors and/or masses as well as low scalability, and poor suitability to large area actuation.

Previously some actuating solutions with elastic structures have been suggested.

US Patent publication US 8587541 B2 discloses one prior art solution for a method for actuating a tactile interface layer, wherein it has been suggested to use small hydraulic system to drive fluid in different reservoirs to generate deformations on a touch surface. The deformations that are to be generated by the hydraulic pumps could be readily observed with a finger touching the surface.

US Patent publication US 9477076 B2 discloses one prior art solution for an electromechanical systems device having flexible support posts, which can be used for optical microelectromechanical systems structures. The presented solution it not suitable for actuating macroscopic structures, for example for tactile feedback applications.

Japanese Patent application publication JP 2007-259663 A discloses one prior art solution for a laminated electrostatic actuator having dielectric structures. The described material structures in the presented solution are not suitable for actuating macroscopic structures, for example for tactile feedback applications.

Document JPH08168099 A discloses an active element structure comprising a plurality of stacked active elements. Each active element comprises a substrate film with an electrode layer, a non-conductive elastic layer comprising a multitude of elastic support nodules and an insulating layer. The active element structure is arranged to compress due to electrostatic attraction between adjacent ones of said stacked active elements.

Documents JP5674222 B2 and JPH06168099 A disclose further active element structures comprising a plurality of stacked active elements.

### BRIEF DESCRIPTION OF THE DRAWINGS

Some embodiments are illustrated by way of example and not limitation in the figures of the accompanying drawings.
FIG. 1 is a conceptual diagram illustrating at least a portion of a single layer of the electrostatic actuator structure, according to one example embodiment of the present invention.
FIG. 2 illustrates a multitude of elastic support nodules according to one example embodiment of the present invention arranged in a spaced two-dimensional row/column grid array.
FIG. 3 illustrates a multitude of elastic support nodules according to another example embodiment of the present invention arranged in a spaced triangular grid array.
FIG. 4 is a conceptual diagram illustrating at least a portion of a single layer of the electrostatic actuator structure, according to another example embodiment of the present invention.
FIG. 5 is a conceptual diagram illustrating at least a portion of an electrostatic actuator structure with four electrostatic actuation layers according to one example embodiment of the present invention.
FIG. 6 is a conceptual diagram illustrating at least a portion of a single layer of the electrostatic actuator structure, according to a third example embodiment of the present invention.
FIG. 7 is a conceptual diagram illustrating at least a portion of an electrostatic actuator structure with six electrostatic actuation layers according to another example embodiment of the present invention.
FIG. 8 is a conceptual diagram illustrating at least a portion of an electrostatic actuator structure with six electrostatic actuation layers according to a third example embodiment of the present invention.
FIG. 9 is a conceptual diagram illustrating at least a portion of an electrostatic actuator structure with six electrostatic actuation layers according to a fourth example embodiment of the present invention.
FIGS. 10A/10B illustrate at least two stacks of electrostatic actuation layers according to one example embodiment of the present invention.
FIGS. 11A/11B illustrate at least two stacks of electrostatic actuation layers according to another example embodiment of the present invention with an additional firm structure.
FIGS. 12A/12B/12C illustrate a conceptual diagram illustrating at least a portion of a single layer of the electrostatic actuator structure, according to a fifth example embodiment of the present invention.
FIGS. 13A/13B/13C/13D illustrate an active element according to an example embodiment of the present invention.
FIGS. 14A/14B/14C/14D/14E/14F illustrate an active element according to another example embodiment of the present invention.
FIGS. 15A/15B/15C/15D/15E illustrate an active element according to a third example embodiment of the present invention.
FIGS. 16A/16B/16C/16D illustrate an active element stack according to an example embodiment of the present invention.
FIGS. 17A/17B/17C/17D/17E/17F illustrate a basic active element composing the active element stack according to another example embodiment of the present invention.
FIGS. 18A/18B/18C illustrate a basic active element composing the active element stack according to a third example embodiment of the present invention.

### DETAILED DESCRIPTION

The invention is defined by the appended claims.

The presented new electrostatic actuator structure is a clear improvement over the prior art solutions. The new electrostatic actuator structure presents various innovative features, which make it suitable for actuating macroscopic structures, for example for tactile feedback applications. In particular, the actuation distances and amplitudes generated with the present invention are much greater and represent different scale levels when compared to the prior art solutions. The presented new electrostatic actuator structure is also suitable for new type of manufacturing methods such as injection molding.

The modular nature of the presented new electrostatic actuator structure, with stacked identical module structures, allows the simple establishment of the final energy in the mechanical actuation (compression amplitude and force), by adding or removing active layers and adapting the power signal accordingly.

The new electrostatic actuator structure described herein comprises a simple to manufacture insulator layer that has the suitable elastic structure incorporated in it and which can compress significantly within suitable voltage range. In our tests the overall area of the elastic nodules was optimally around 1% of the whole fluid space, this representing a substantive improvement when compared to the prior art solutions.

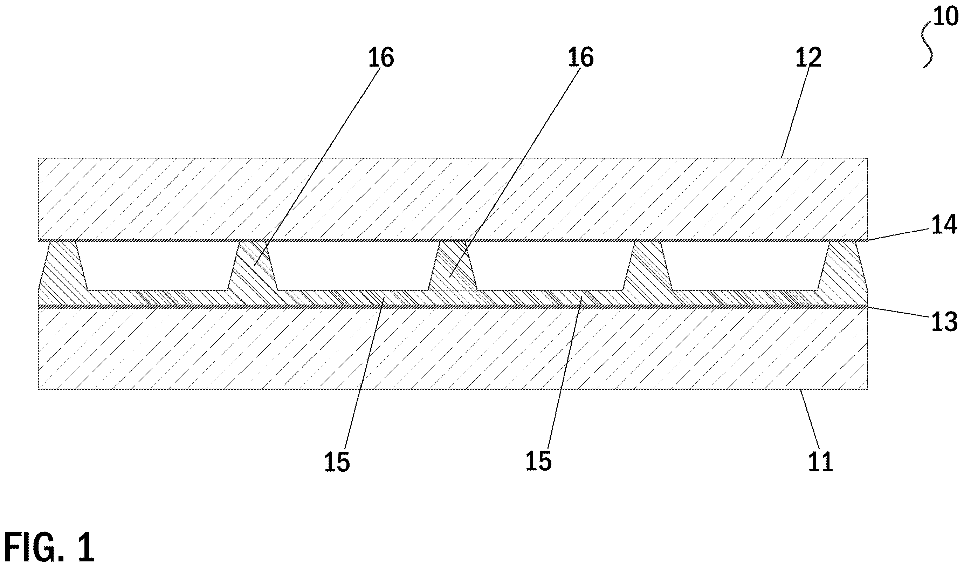

FIG. 1 is a conceptual diagram illustrating at least a portion of a single electrostatic actuation layer of the electrostatic actuator structure, according to one example embodiment of the present invention. The illustrated single electrostatic actuation layer 10 of the electrostatic actuator structure comprises a first substrate film 11 and a second substrate film 12. In the presented example embodiment of FIG. 1 the first substrate film 11 and the second substrate film 12 have a thickness of 100 micrometers (100 µm). The first substrate film 11 is normally of electrically insulating material but may also be intrinsically conductive or semi-conductive. In the presented example embodiment of FIG. 1 the first substrate film 11 comprises a first conductive/semiconductive electrode layer 13 applied on top of the first substrate film 11, said first conductive/semiconductive electrode layer 13 being a part of a first electrode. The second substrate film 12 is normally of electrically insulating material but may also be intrinsically conductive or semi-conductive. In the presented example embodiment of FIG. 1 the second substrate film 12 comprises a second conductive/semiconductive electrode layer 14 applied on top of the second substrate film 12 said second conductive/semiconductive electrode layer 14 being a part of a second electrode. In the presented example embodiment of FIG. 1 said first conductive/semiconductive electrode layer 13 is insulated. In an alternative embodiment of the present invention, said second conductive/semiconductive electrode layer 14 is insulated. Furthermore, in another alternative embodiment of the present invention said first conductive/semiconductive electrode layer 13 and said second conductive/semiconductive electrode layer 14 are both insulated.

An advantage of using semi-conductive material instead of fully conductive, i.e. having metallic conductivity, in said first substrate film 11 and said second first substrate film 12 and/or said first conductive/semiconductive electrode layer 13 and said second conductive/semiconductive electrode layer 14 may be that of the possibility to use more cost effective material especially in case if transparency is expected from the electrode, or if high flexibility and/or some elasticity is desired. The use of semi-conductive material also increases the safety of the device, preventing strong electric discharge in the case of accidental failure.

The first substrate film 11 with said insulated first conductive/semiconductive electrode layer 13 has a layer of electrically insulating elastic material 15, e.g. electrically insulating elastomer coating 15 applied on top of said insulated first conductive/semiconductive electrode layer 13 of the first substrate film 11. Furthermore, there is a multitude of elastic support nodules 16 arranged in a grid array and adhered on top, or forming part of the intrinsic structure of said layer of electrically insulating elastic material 15 of said insulated first conductive/semiconductive electrode layer 13 of the first substrate film 11.

In examples not being part of the present invention, the elastic base layer 15 may not be present, and only the elastic support nodules 16 will be present in the region between both conductive/semiconductive electrode layers, 13 and 14.

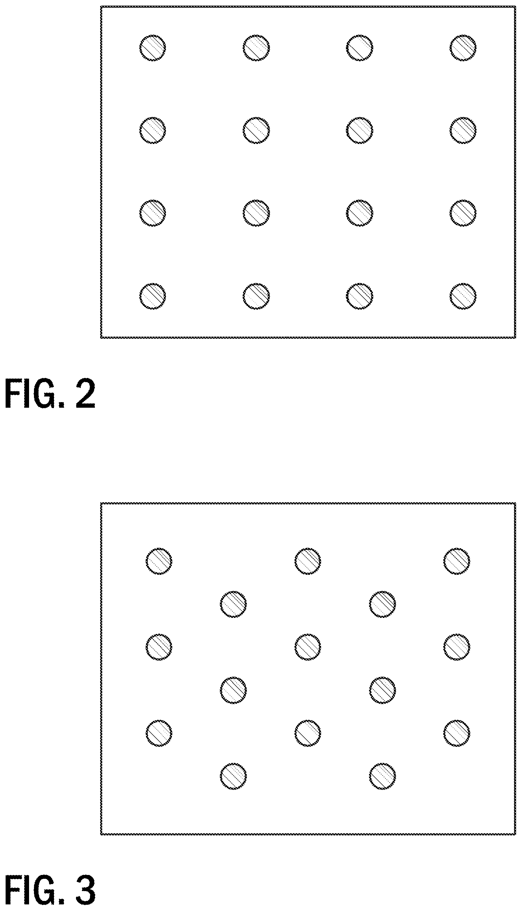

In the presented example embodiment of FIG. 1 said layer of electrically insulating elastic material 15 has a thickness of 20 micrometers (20 µm) and said multitude of elastic support nodules 16 have a height of 60 micrometers (60 µm) and a diameter of 60 micrometers (60 µm). Said multitude of elastic support nodules 16 may have a height to maximum width aspect ratio with a maximum value of two (2). The layer of electrically insulating elastic material 15 and/or said multitude of elastic support nodules 16 may be applied using a suitable deposition technique e.g. a thin film deposition technique. Said multitude of elastic support nodules 16 may be made of silicon-based organic polymer, e.g. polydimethylsiloxane (PDMS). Said multitude of elastic support nodules 16 may be arranged less than 10 mm distance apart from each other, preferably less than 2 mm distance apart from each other. Said multitude of elastic support nodules 16 may have shape that is cone-like with thicker base than the tip. This form factor is especially suitable in injection molding to have smooth detachment of elastic layer from the mold. Said multitude of elastic support nodules 16 may e.g. be arranged in a grid array of a spaced two-dimensional row/column grid array as illustrated in FIG. 2. Alternatively, said multitude of elastic support nodules 16 may be arranged in a grid array of a spaced triangular grid array as illustrated in FIG. 3.

After said multitude of elastic support nodules 16 have been applied on the first substrate film 11 the second substrate film 12 with said second conductive/semiconductive electrode layer 14 is turned upside down and placed on top of the multitude of elastic support nodules 16 to form an electrostatic actuation layer. Before placing said second substrate film 12 on top of the first substrate film 11 and the multitude of elastic support nodules 16 there may be adhesive applied to said second substrate film 12 and/or to said multitude of elastic support nodules 16. As said first substrate film 11 and said second substrate film 12 have been stacked one above the other as an electrostatic actuation layer, the distance between said first conductive/semiconductive electrode layer 13 and said second conductive/semiconductive electrode layer 14, i.e. the distance between electrodes, in said electrostatic actuation layer may be less than 1000 micrometers (1000 µm) and preferably less than 200 micrometers (200 µm). In said electrostatic actuation layer the presented example embodiment of FIG. 1 said distance between said first and second conductive/semiconductive electrode layers 13, 14 is 80 micrometers (80 µm).

In said electrostatic actuation layer, said multitude of elastic support nodules 16 provide a compression space between said first and second conductive/semiconductive electrode layers 13, 14, said compression space not entirely filled with solid material. In the presented example embodiment of FIG. 1 said compression space is 80 micrometers (80 µm) thick and has a 20 micrometers (20 µm) thick electrically insulating elastic material layer 15 thus leaving a space gap of 60 micrometers (60 µm), which space gap of said compression space may be filled with fluid, e.g. air, nitrogen or a dielectric liquid for example dielectric hydraulic fluid. In the presented example embodiment at least one of said electrostatic actuation layers may also comprise a grid array comprising a multitude of limiting nodules, said multitude of limiting nodules arranged between elastic support nodules and between said first substrate film and said second substrate film, for limiting the compression of said electrostatic actuator structure. In the presented example embodiment the surfaces of said first and second conductive/semiconductive electrode layers 13, 14 on both sides of said space gap and the elastic support nodules 16 may be inherently hydrophobic or hydrophobically or superhydrophobically coated or hydrophobically or superhydrophobically treated.

The electrostatic actuator structure according to the present invention is arranged to compress when sufficient voltage difference is applied between said at least a first electrode and a second electrode. Said electrostatic actuator structure may be embedded as part of a flexible substrate. Said electrostatic actuator structure is not necessarily flat, and can be flexible, and may be embedded as part of a rigid, not necessarily flat, or flexible substrate. The illustrated single electrostatic actuation layer 10 of the electrostatic actuator structure has an overall thickness of 280 micrometers (280 µm) added with the thickness of said first and second conductive/semiconductive electrode layers 13, 14 and the thickness of said adhesive 107 this giving an overall thickness of approximately 290 micrometers (290 µm).

The inventors have observed that the system is very specific for the nodule spacing and dimensions. For the macroscopic actuation applications, which the system has been designed for, for example, dimensions of 100-micrometer tall nodules with 100-micrometer diameter and 1 millimeter spacing, work well with typical silicone rubber hardness. Such nodules may for example compress 10 to 30 micrometers when potential difference of around 1 KV voltage is applied. The amplitude and strength of the actuation can be increased by stacking several layers on top of one another.

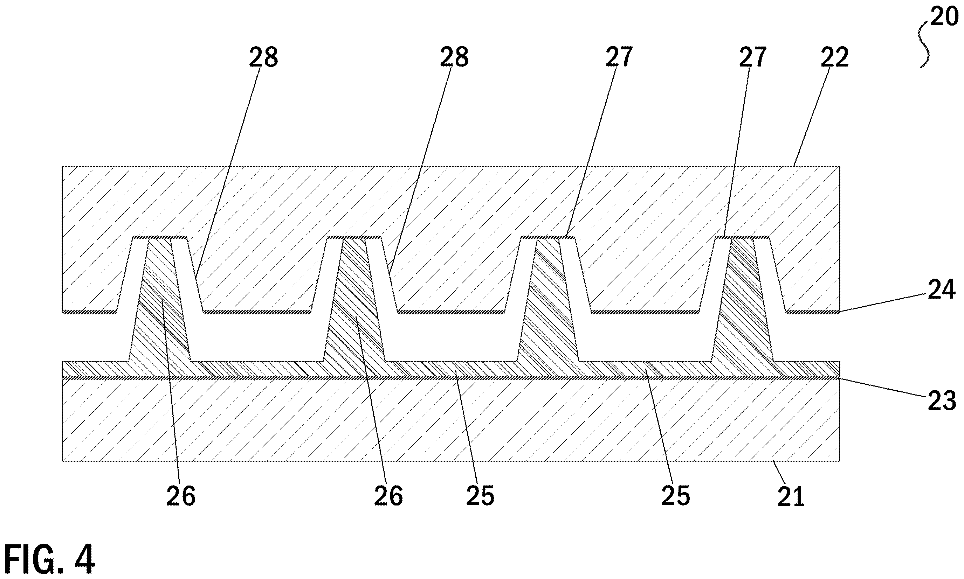

FIG. 4 is a conceptual diagram illustrating at least a portion of a single electrostatic actuation layer of the electrostatic actuator structure, according to another example embodiment of the present invention. The illustrated single electrostatic actuation layer 20 of the electrostatic actuator structure comprises a first substrate film 21 and a second substrate film 22. In the presented example embodiment of FIG. 4 the first substrate film 21 has a thickness of 100 micrometers (100 µm) and the second substrate film 22 has a thickness of 175 micrometers (175 µm). The first substrate film 21 is normally of electrically insulating material but may also be intrinsically conductive or semi-conductive. In the presented example embodiment of FIG. 4 the first substrate film 21 comprises a first conductive/semiconductive electrode layer 23 applied on top of the first substrate film 21, said first conductive/semiconductive electrode layer 23 being a part of a first electrode. The second substrate film 22 is normally of electrically insulating material but may also be intrinsically conductive or semi-conductive. In the presented example embodiment of FIG. 4 the second substrate film 22 comprises a second conductive/semiconductive electrode layer 24 applied on top of the second substrate film 22 said second conductive/semiconductive electrode layer 24 being a part of a second electrode. In the presented example embodiment of FIG. 4 said first conductive/semiconductive electrode layer 23 is insulated. In an alternative embodiment of the present invention, said second conductive/semiconductive electrode layer 24 is insulated. Furthermore, in another alternative embodiment of the present invention said first conductive/semiconductive electrode layer 23 and said second conductive/semiconductive electrode layer 24 are both insulated.

An advantage of using semi-conductive material instead of fully conductive, i.e. having metallic conductivity, in said first substrate film 21 and said second first substrate film 22 and/or said first conductive/semiconductive electrode layer 23 and said second conductive/semiconductive electrode layer 24 may be that of the possibility to use more cost effective material especially in case if transparency is expected from the electrode, or if high flexibility and/or some elasticity is desired. The use of semi-conductive material also increases the safety of the device, preventing strong electric discharge in the case of accidental failure.

The first substrate film 21 with said insulated first conductive/semiconductive electrode layer 23 has a layer of electrically insulating elastic material 25, e.g. electrically insulating elastomer coating 25 applied on top of said insulated first conductive/semiconductive electrode layer 23 of the first substrate film 21. Furthermore, there is a multitude of elastic support nodules 26 arranged in a grid array and adhered on top, or forming part of the intrinsic structure of said layer of electrically insulating elastic material 25 of said insulated first conductive/semiconductive electrode layer 23 of the first substrate film 21.

In examples not being part of the present invention, the elastic base layer 25 may not be present, and only the elastic support nodules 26 will be present in the region between both conductive/semiconductive electrode layers, 23 and 24.

In the presented example embodiment of FIG. 4 said layer of electrically insulating elastic material 25 has a thickness of 20 micrometers (20 µm) and said multitude of elastic support nodules 26 have a height of 150 micrometers (150 µm). Said multitude of elastic support nodules 26 may have a height to maximum width aspect ratio with a maximum value of two (2). The layer of electrically insulating elastic material 25 and/or said multitude of elastic support nodules 26 may be applied using a suitable microfabrication technique e.g. a thin film deposition technique. Said multitude of elastic support nodules 26 may be made of silicon-based organic polymer, e.g. polydimethylsiloxane (PDMS). Said multitude of elastic support nodules 26 may be arranged less than 10 mm distance apart from each other, preferably less than 2 mm distance apart from each other. Said multitude of elastic support nodules 26 may have shape that is cone-like with thicker base than the tip. This form factor is especially suitable in injection molding to have smooth detachment of elastic layer from the mold. Said multitude of elastic support nodules 26 may e.g. be arranged in a grid array of a spaced two-dimensional row/column grid array as illustrated in FIG. 2. Alternatively, said multitude of elastic support nodules 26 may be arranged in a grid array of a spaced triangular grid array as illustrated in FIG. 3.

The second substrate film 22 is microfabricated e.g. etched in order to provide wells 28 to said second substrate film 22, said wells 28 arranged to match the multitude of elastic support nodules 26 of the first substrate film 21. The wells 28 may be microfabricated using a suitable microfabrication technique e.g. an anisotropic wet etching technique. The microfabricated second substrate film 22 with said second conductive/semiconductive electrode layer 24 is turned upside down and placed on top of the multitude of elastic support nodules 26 of the first substrate film 21 so that the wells 28 coincide with the multitude of elastic support nodules 26 to form an electrostatic actuation layer. In said electrostatic actuation layer, the elastic support nodules 26 reside in said wells 28. Before placing said second substrate film 22 on top of the multitude of elastic support nodules 26 there may be adhesive 27 applied to said wells 28 and/or to said multitude of elastic support nodules 26. In the presented example embodiment of FIG. 4 said depth of said wells 28 is 90 micrometers (90 µm). Other suitable depths may be used also depending on the thickness of the second substrate film 22 to be microfabricated.

As said first substrate film 21 and said second substrate film 22 have been stacked one above the other as an electrostatic actuation layer, the distance between said first conductive/semiconductive electrode layer 23 and said second conductive/semiconductive electrode layer 24, i.e. the distance between electrodes, in said electrostatic actuation layer may be less than 1000 micrometers (1000 µm) and preferably less than 200 micrometers (200 µm). In said electrostatic actuation layer the presented example embodiment of FIG. 4 said distance between said first and second conductive/semiconductive electrode layers 23, 24 is 80 micrometers (80 µm). Due to the wells 28 of said second substrate film 22 matching the multitude of elastic support nodules 26 of said first substrate film 21 said distance between said first and second conductive/semiconductive electrode layers 23, 24 is considerably less than the height of the multitude of elastic support nodules 26. This is the main advantage of this type of configuration, since the shorter distance between electrodes allows stronger electrostatic compression forces for a same nodule height. Eventually, this leads to higher compressing ratios for similar actuation forces.

In said electrostatic actuation layer, said multitude of elastic support nodules 26 provide a compression space between said first and second conductive/semiconductive electrode layers 23, 24, said compression space not entirely filled with solid material. In the presented example embodiment of FIG. 4 said compression space is 80 micrometers (80 µm) thick and has a 20 micrometers (20 µm) thick electrically insulating elastic material layer 25 thus leaving a space gap of 60 micrometers (60 µm), which space gap of said compression space may be filled with fluid, e.g. air, nitrogen or a dielectric liquid for example dielectric hydraulic fluid. In the presented example embodiment at least one of said electrostatic actuation layers may also comprise a grid array comprising a multitude of limiting nodules, said multitude of limiting nodules arranged between elastic support nodules and between said first substrate film and said second substrate film, for limiting the compression of said electrostatic actuator structure. In the presented example embodiment the surfaces of said first and second conductive/semiconductive electrode layers 23, 24 on both sides of said space gap of said compression space and the elastic support nodules 26 may be inherently hydrophobic or hydrophobically or superhydrophobically coated or hydrophobically or superhydrophobically treated.

The electrostatic actuator structure according to the present invention is arranged to compress when sufficient voltage difference is applied between said at least a first electrode and a second electrode. Said electrostatic actuator structure may be embedded as part of a flexible substrate. Said electrostatic actuator structure is not necessarily flat, can be flexible, and may be embedded as part of a rigid, not necessarily flat, or flexible substrate. The illustrated single electrostatic actuation layer 20 of the electrostatic actuator structure has an overall thickness of 355 micrometers (355 µm) added with the thickness of said first and second conductive/semiconductive electrode layers 23, 24 and the thickness of said adhesive 27 this giving an overall thickness of approximately 365 micrometers (365 µm).

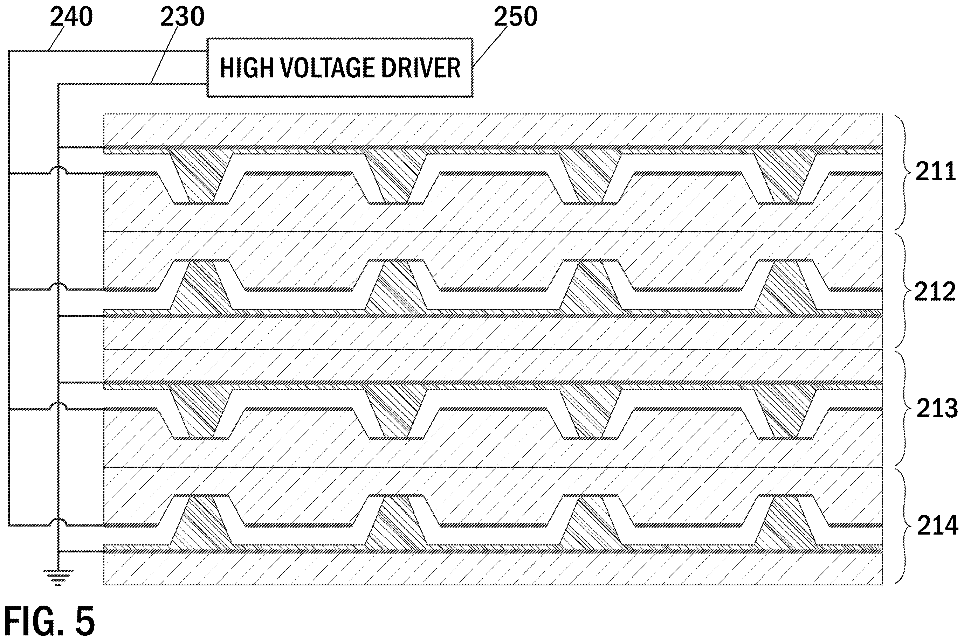

FIG. 5 is a conceptual diagram illustrating at least a portion of an electrostatic actuator structure with four electrostatic actuation layers according to one example embodiment of the present invention. The illustrated electrostatic actuator structure comprises four electrostatic actuation layers 211 - 214. In the presented example embodiment of FIG. 5 each of the electrostatic actuation layers 211-214 comprise a first substrate film with a first conductive/semiconductive electrode layer said first conductive/semiconductive electrode layer being a part of a first electrode 230, and a second substrate film with a second conductive/semiconductive electrode layer said second conductive/semiconductive electrode layer being a part of a second electrode 240, at least one of said first and second conductive/semiconductive electrode layers being insulated from the other conductive/semiconductive electrode layers, and a grid array comprising a multitude of elastic support nodules, said multitude of elastic support nodules arranged between said first substrate film and said second substrate film, so that there is arranged a compression space between said first and second conductive/semiconductive electrode layers, said compression space not entirely filled with solid material. The electrostatic actuator structure according to the present invention may also comprise a High Voltage Driver 250, e.g. a High Voltage Driver with a Flyback-mode boost converter.

In the presented example embodiment of FIG. 5 each of the electrostatic actuation layers 211-214 are stacked one above the other so that similar structural elements of said electrostatic actuation layers 211-214 coincide at least partially, preferably coincide fully. The electrostatic actuator structure according to the present invention is arranged to compress when sufficient voltage difference is applied between said first electrode 230 and said second electrode 240. Due to the coinciding, adhered and joint structure of the said electrostatic actuation layers 211-214 the compression effect of said electrostatic actuator structure is increased substantially as function of the number of coinciding layers. With the help of the adhered and joint structure of the said electrostatic actuation layers 211-214 the hole above is avoided and the potential reduction of the effect due to the potential inter-pillar swallowing for air compression is covered. Furthermore, potential inter layer bouncing or nonuniform separation is also avoided.

As each of the electrostatic actuation layers 211-214 have an overall thickness of approximately 365 micrometers (365 µm) the thickness for the electrostatic actuator structure with four electrostatic actuation layers according to presented example embodiment is approximately four times 365 micrometers (4 x 365 µm) this giving for the electrostatic actuator structure a total thickness of approximately 1.46 millimeters (1.46 mm). The electrostatic actuator structure according to the present invention may be hermetically sealed.

The described compressing nodule structure together with the hermetic sealing, allows using the compression of the layers as pneumatic pump structure. The gas or liquid material can be used to actuate various elastic structures that are affected by the pressure, creating a textured surface or actuating some part of system via pneumatic or hydraulic means.

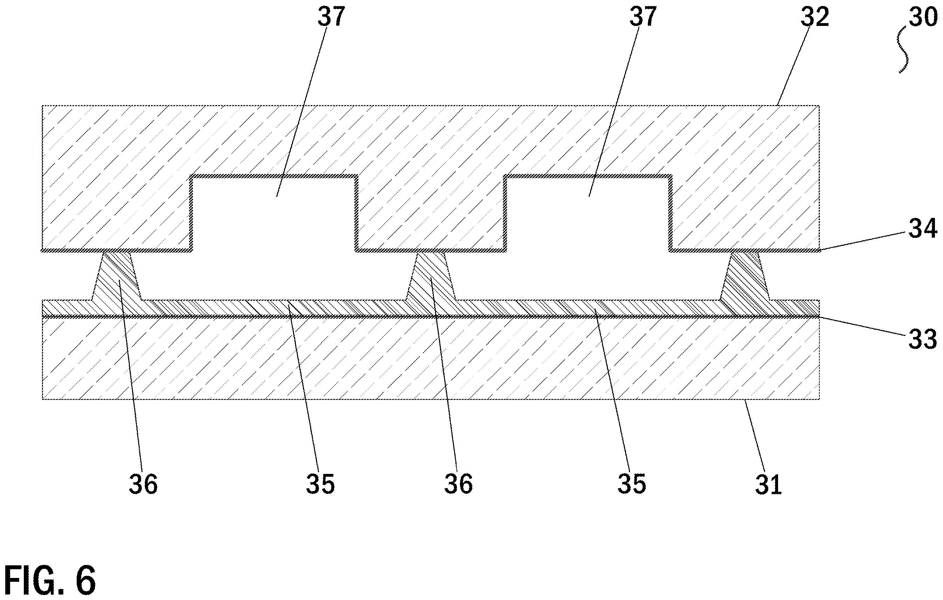

FIG. 6 is a conceptual diagram illustrating at least a portion of a single electrostatic actuation layer of the electrostatic actuator structure, according to a third example embodiment of the present invention. The illustrated single electrostatic actuation layer 30 of the electrostatic actuator structure comprises a first substrate film 31 and a second substrate film 32. In the presented example embodiment of FIG. 6 the first substrate film 31 has a thickness of 100 micrometers (100 µm) and the second substrate film 32 has a thickness of 175 micrometers (175 µm). The first substrate film 31 is normally of electrically insulating material but may also be intrinsically conductive or semi-conductive. In the presented example embodiment of FIG. 6 the first substrate film 31 comprises a first conductive/semiconductive electrode layer 33 applied on top of the first substrate film 31, said first conductive/semiconductive electrode layer 33 being a part of a first electrode. The second substrate film 32 is normally of electrically insulating material but may also be intrinsically conductive or semi-conductive. In the presented example embodiment of FIG. 6 the second substrate film 32 comprises a second conductive/semiconductive electrode layer 34 applied on top of the second substrate film 32 said second conductive/semiconductive electrode layer 34 being a part of a second electrode. One or both of the said first conductive/semiconductive electrode layer 33 and said second conductive/semiconductive electrode layer 34 are insulated.

An advantage of using semi-conductive material instead of fully conductive, i.e. having metallic conductivity, in said first substrate film 31 and said second first substrate film 32 and/or said first conductive/semiconductive electrode layer 33 and said second conductive/semiconductive electrode layer 34 may be that of the possibility to use more cost effective material especially in case if transparency is expected from the electrode, or if high flexibility and/or some elasticity is desired.

The first substrate film 31 with said insulated first conductive/semiconductive electrode layer 33 has a layer of electrically insulating elastic material 35, e.g. electrically insulating elastomer coating 35 applied on top of said insulated first conductive/semiconductive electrode layer 33 of the first substrate film 31. Furthermore, there is a multitude of elastic support nodules 36 arranged in a grid array and adhered on top, or forming part of the intrinsic structure of said layer of electrically insulating elastic material 35 of said insulated first conductive/semiconductive electrode layer 33 of the first substrate film 31. In the presented example embodiment of FIG. 6 said layer of electrically insulating elastic material 35 has a thickness of 20 micrometers (20 µm) and said multitude of elastic support nodules 36 have a height of 80 micrometers (80 µm). Said multitude of elastic support nodules 36 may have a height to maximum width aspect ratio with a maximum value of two (2). The layer of electrically insulating elastic material 35 and/or said multitude of elastic support nodules 36 may be applied using a suitable microfabrication technique e.g. a thin film deposition technique. Said multitude of elastic support nodules 36 may be made of silicon-based organic polymer, e.g. polydimethylsiloxane (PDMS). Said multitude of elastic support nodules 36 may be arranged less than 10 mm distance apart from each other, preferably less than 2 mm distance apart from each other. Said multitude of elastic support nodules 16 may have shape that is cone-like with thicker base than the tip. This form factor is especially suitable in injection molding to have smooth detachment of elastic layer from the mold. Said multitude of elastic support nodules 36 may e.g. be arranged in a grid array of a spaced two-dimensional row/column grid array as illustrated in FIG. 2. Alternatively, said multitude of elastic support nodules 36 may be arranged in a grid array of a spaced triangular grid array as illustrated in FIG. 3.

Furthermore, the electrostatic actuator structure according to the present example embodiment comprises gas reservoirs 37, e.g. air reservoirs allowing decreased overall air compression when the air compresses or moves from a compressing layer. The second substrate film 32 is microfabricated e.g. etched in order to provide gas reservoirs 37, e.g. air reservoirs 37, to said second substrate film 32, said gas reservoirs 37 arranged to reduce the compression ratio of air volume. The gas reservoirs 37 may be microfabricated using a suitable microfabrication technique e.g. an anisotropic wet etching technique. The microfabricated second substrate film 32 with said second conductive/semiconductive electrode layer 34 is turned upside down and placed on top of the multitude of elastic support nodules 36 to form an electrostatic actuation layer. In the presented example embodiment of FIG. 6 said depth of said gas reservoirs 37 is 90 micrometers (90 µm). Other suitable depths may be used also depending on the thickness of the second substrate film 32 to be microfabricated. Furthermore, the depth of said gas reservoirs 37 can be the same as the thickness of the second substrate film 32, so that they form holes through it.

The inventors have observed that the system is very specific for the nodule spacing and dimensions. For the macroscopic actuation applications, which the system has been designed for, for example, dimensions of 100-micrometer tall nodules with 100-micrometer diameter and 1 millimeter spacing, work well with typical silicone rubber hardness. Such nodules may for example compress 10 to 30 micrometers when potential difference of around 1 KV voltage is applied. The amplitude and strength of the actuation can be increased by stacking several layers on top of one another.

In addition, the resistance of the semi conductive layer may be selected so that the said actuator structure can be positioned on top of capacitive touch sensor or capacitive touch panel and allow the touch sensor sense through the layer. This is possible because the capacitive touch sensors or capacitive touch panel typically uses over 100 kHz signals for sensing purposes, whereas the present actuator is typically driven with signals below 500 Hz. Therefore it is possible to make the actuator electrodes of material that is semi conductive for example between 100kOhm/square to 100MOhm/square of surface resistance, wherein they can be charged sufficiently fast for the actuator to actuate, but they will appear as insulating layer to touch panels much higher frequency sensing signal. The semi-conductiveness of a first substrate film and a second substrate film may be selected so that said first substrate film and said second substrate film appear as insulating layer to a higher frequency sensing signal.

The use of semi conductive material may have yet another benefit, in case the said actuator is exposed to for example a puncture risk by conductive object, the semi conductive material works as natural current limiting method providing additional safety benefit.

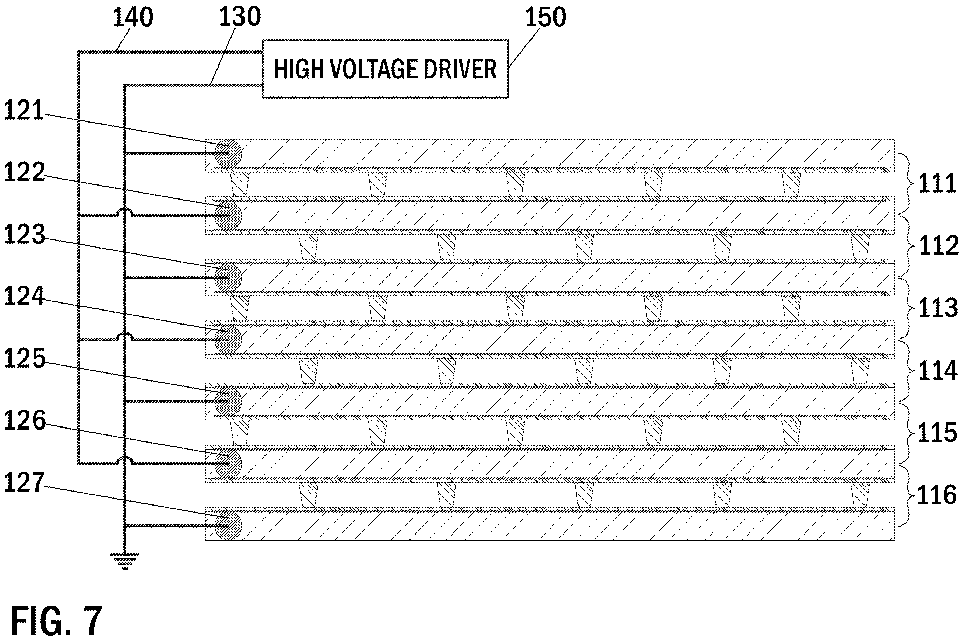

FIG. 7 is a conceptual diagram illustrating at least a portion of an electrostatic actuator structure with six electrostatic actuation layers according to another example embodiment of the present invention. The illustrated electrostatic actuator structure comprises six electrostatic actuation layers 111-116. In the presented example embodiment of FIG. 7 each of the electrostatic actuation layers 111-116 comprise a first substrate film with a first conductive/semiconductive electrode layer said first conductive/semiconductive electrode layer being a part of a first electrode 130, and a second substrate film with a second conductive/semiconductive electrode layer said second conductive/semiconductive electrode layer being a part of a second electrode 140, at least one of said first and second conductive/semiconductive electrode layers being insulated from the other conductive/semiconductive electrode layers, said electrostatic actuation layers 111-116 being stacked one above another as a stack of electrostatic actuation layers so that in the middle of said stack a bifunctional substrate film forms a first substrate film or a second substrate film for two of said electrostatic actuation layers 111-116, one below said bifunctional substrate film and another above said bifunctional substrate film. The electrostatic actuator structure according to the present invention may also comprise a High Voltage Driver 150, e.g. a High Voltage Driver with a Flyback-mode boost converter. Furthermore, each of the substrate films in said stack of electrostatic actuation layers may comprise an embedded connection element 121-127, e.g. an embedded metal wire 121-127, said embedded connection element 121-127 connecting the conductive/semiconductive electrode layer/layers to said High Voltage Driver 150. In the middle of said stack of electrostatic actuation layers, the embedded connection elements 122-126 connect the conductive/semiconductive electrode layers of said bifunctional substrate film together and to said High Voltage Driver 150.

Each of the electrostatic actuation layers 111-116 also comprise a grid array comprising a multitude of elastic support nodules, said multitude of elastic support nodules arranged between said first substrate film and said second substrate film, so that there is arranged a compression space between said first and second conductive/semiconductive electrode layers, said compression space not entirely filled with solid material.

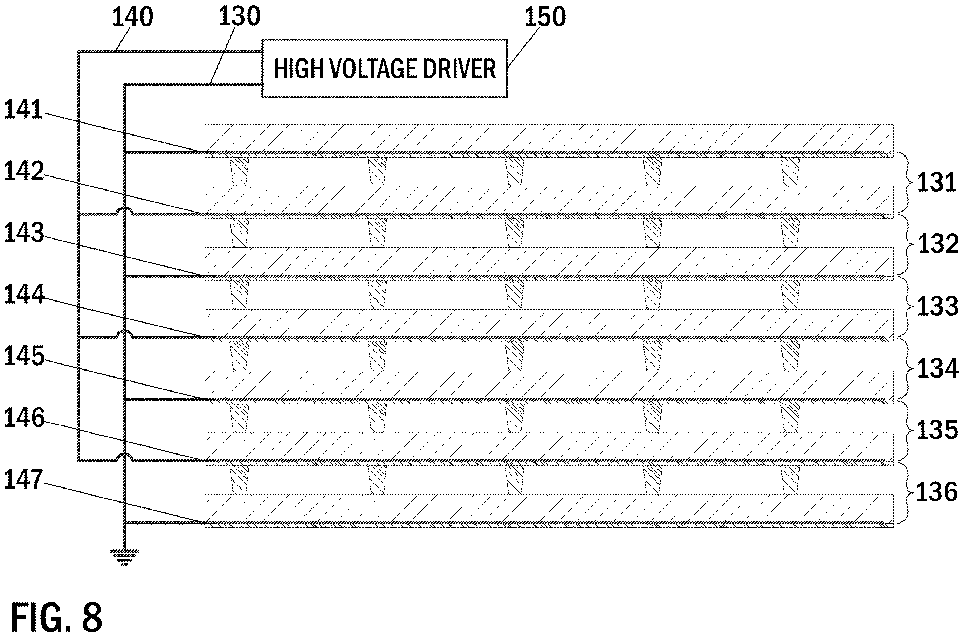

FIG. 8 is a conceptual diagram illustrating at least a portion of an electrostatic actuator structure with six electrostatic actuation layers according to a third example embodiment of the present invention. The illustrated electrostatic actuator structure comprises six electrostatic actuation layers 131-136. In the presented example embodiment of FIG. 8 each of the electrostatic actuation layers 131-136 comprise a first substrate film with a first conductive/semiconductive electrode layer said first conductive/semiconductive electrode layer being a part of a first electrode 130, and a second substrate film with a second conductive/semiconductive electrode layer said second conductive/semiconductive electrode layer being a part of a second electrode 140, at least one of said first and second conductive/semiconductive electrode layers being insulated from the other conductive/semiconductive electrode layers, said electrostatic actuation layers 131-136 being stacked one above another as a stack of electrostatic actuation layers so that in the middle of said stack a bifunctional substrate film forms a first substrate film or a second substrate film for two of said electrostatic actuation layers 131-136, one below said bifunctional substrate film and another above said bifunctional substrate film. Furthermore, in the middle of said stack of electrostatic actuation layers a bifunctional conductive/semiconductive electrode layer of said bifunctional substrate film is arranged to act as a conductive/semiconductive electrode layer for a two of said electrostatic actuation layers 131-136, one below said bifunctional conductive/semiconductive electrode layer and another above said bifunctional conductive/semiconductive electrode layer.

The electrostatic actuator structure according to the present invention may also comprise a High Voltage Driver 150, e.g. a High Voltage Driver with a Flyback-mode boost converter. Furthermore, each of the substrate films in said stack of electrostatic actuation layers may comprise an embedded connection element 141-147, said embedded connection element 141-147 connecting the conductive/semiconductive electrode layer/coatings to said High Voltage Driver 150.

Each of the electrostatic actuation layers 131-136 also comprise a grid array comprising a multitude of elastic support nodules, said multitude of elastic support nodules arranged between said first substrate film and said second substrate film, so that there is arranged a compression space between said first and second conductive/semiconductive electrode layers, said compression space not entirely filled with solid material.

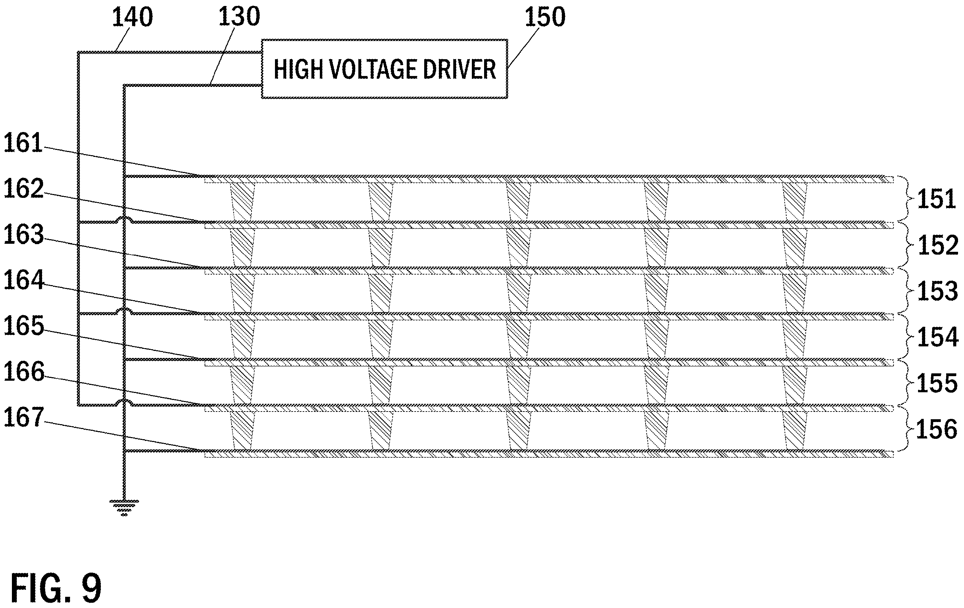

FIG. 9 is a conceptual diagram illustrating at least a portion of an electrostatic actuator structure with six electrostatic actuation layers according to a fourth example embodiment of the present invention. The illustrated electrostatic actuator structure comprises six electrostatic actuation layers 151-156. In the presented example embodiment of FIG. 9 each of the electrostatic actuation layers 151-156 comprise a first substrate film with a first conductive/semiconductive electrode layer said first conductive/semiconductive electrode layer being a part of a first electrode 130, and a second substrate film with a second conductive/semiconductive electrode layer said second conductive/semiconductive electrode layer being a part of a second electrode 140, at least one of said first and second conductive/semiconductive electrode layers being insulated from the other conductive/semiconductive electrode layers, said electrostatic actuation layers 151-156 being stacked one above another as a stack of electrostatic actuation layers so that in the middle of said stack a bifunctional electrically insulating elastic material layer forms a first substrate film or a second substrate film for two of said electrostatic actuation layers 151-156, one below said bifunctional electrically insulating elastic material layer and another above said bifunctional electrically insulating elastic material layer. Furthermore, in the middle of said stack of electrostatic actuation layers a bifunctional conductive/semiconductive electrode layer of said bifunctional electrically insulating elastic material layer is arranged to act as a conductive/semiconductive electrode layer for a two of said electrostatic actuation layers 151-156, one below said bifunctional conductive/semiconductive electrode layer and another above said bifunctional conductive/semiconductive electrode layer.

The electrostatic actuator structure according to the present invention may also comprise a High Voltage Driver 150, e.g. a High Voltage Driver with a Flyback-mode boost converter. Furthermore, each on the substrate films in said stack of electrostatic actuation layers may comprise an embedded connection element 161-167, said embedded connection element 161-167 connecting the conductive/semiconductive electrode layer/coatings to said High Voltage Driver 150.

Each of the electrostatic actuation layers 151-156 also comprise a grid array comprising a multitude of elastic support nodules, said multitude of elastic support nodules arranged between said first substrate film and said second substrate film, so that there is arranged a compression space between said first and second conductive/semiconductive electrode layers, said compression space not entirely filled with solid material.

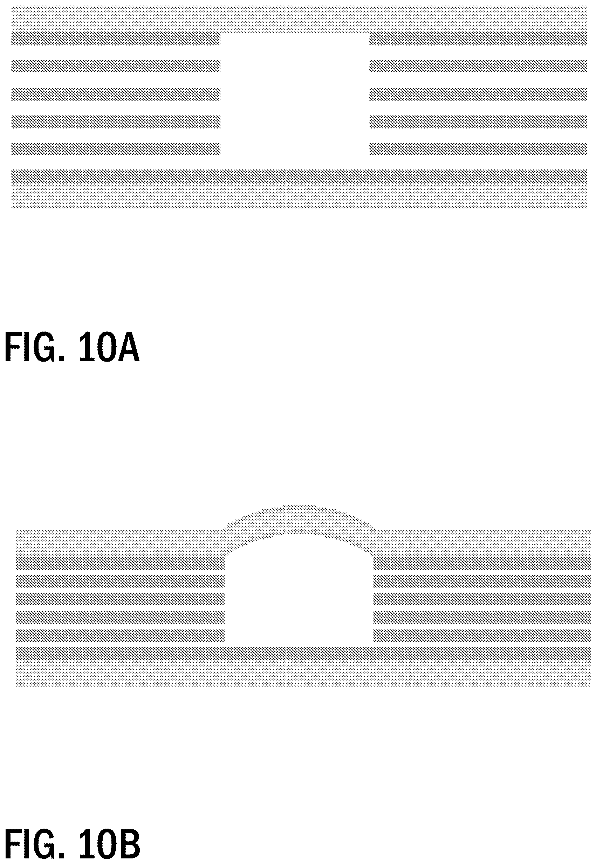

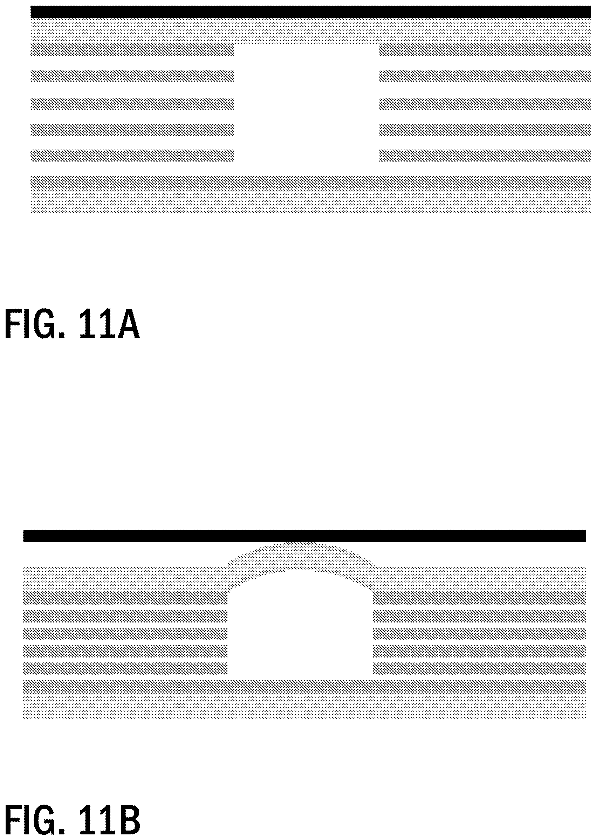

Said two or more electrostatic actuation layers of said electrostatic actuator structure may comprise several electrostatic actuation layers stacked one above the other to form at least two stacks of electrostatic actuation layers as illustrated in FIG. 10A, FIG. 10B, FIG. 11A and FIG. 11B. In the presented example embodiments the surfaces of said first and second conductive/semiconductive electrode layers on both sides of said space gap and the elastic support nodules may be inherently hydrophobic or hydrophobically or superhydrophobically coated or hydrophobically or superhydrophobically treated.

FIGS. 10A/10B and FIGS. 11A/11B present an electrostatic actuator structure with at least two stacks of electrostatic actuation layers with at least one gas reservoir, e.g. air reservoir, arranged between said at least two stacks of electrostatic actuation layers and an elastic surface layer arranged on top of said at least two stacks of electrostatic actuation layers and on top of said at least one gas reservoir. In FIGS. 11A/11B, said electrostatic actuator structure also has an additional firm structure on top of said elastic surface layer. FIGS. 10A/11A present said electrostatic actuator structure when being in a state of rest. FIGS. 10B/11B present said electrostatic actuator structure when being compressed so that said elastic surface layer on top of said at least one gas reservoir bulges accordingly.

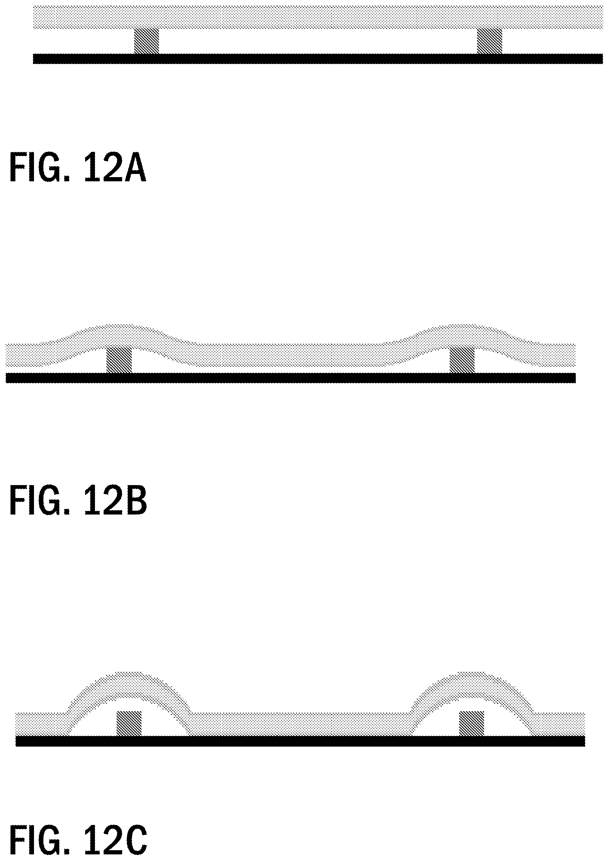

FIGS. 12A/12B/12C illustrate a conceptual diagram illustrating at least a portion of a single layer of the electrostatic actuator structure, according to a fifth example embodiment of the present invention. In FIGS. 12A/12B/12C, said electrostatic actuator structure has a flexible upper substrate.

FIG. 12A presents said electrostatic actuator structure when being in a state of rest. FIG. 12B presents said electrostatic actuator structure when being partially compressed. FIG. 12C presents said electrostatic actuator structure when being fully compressed. In FIGS. 12B/12C, as the flexible upper substrate of said electrostatic actuator structure is being compressed the excess gas bulges in the positions of support nodules.

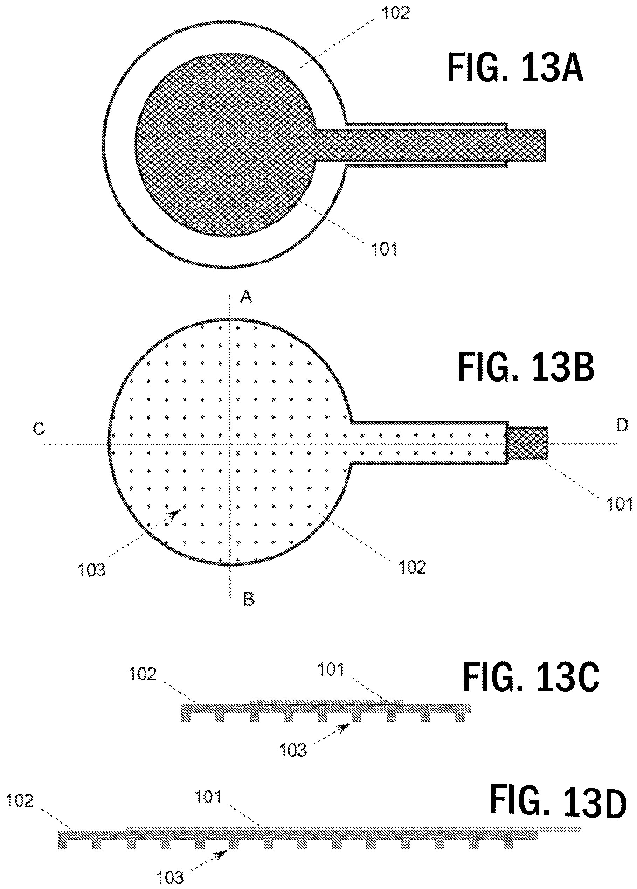

FIGS. 13A/13B/13C/13D illustrate an active element according to an example embodiment of the present invention. Figures 13A and 13B are top and bottom views of an active element, respectively. Figures 13C and 13D are profile view sections of the active element across the axes AB and CD, respectively, as depicted in Figure 13B.

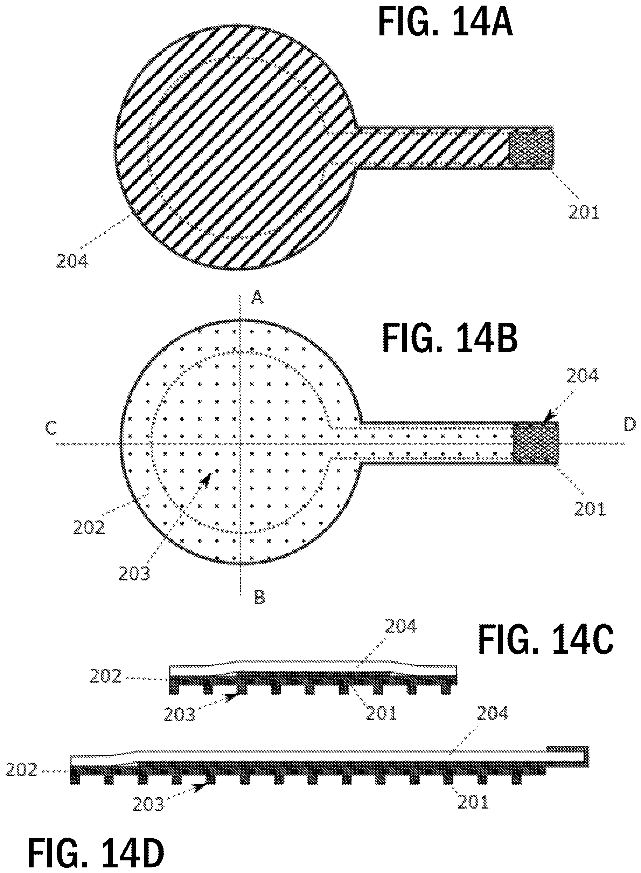

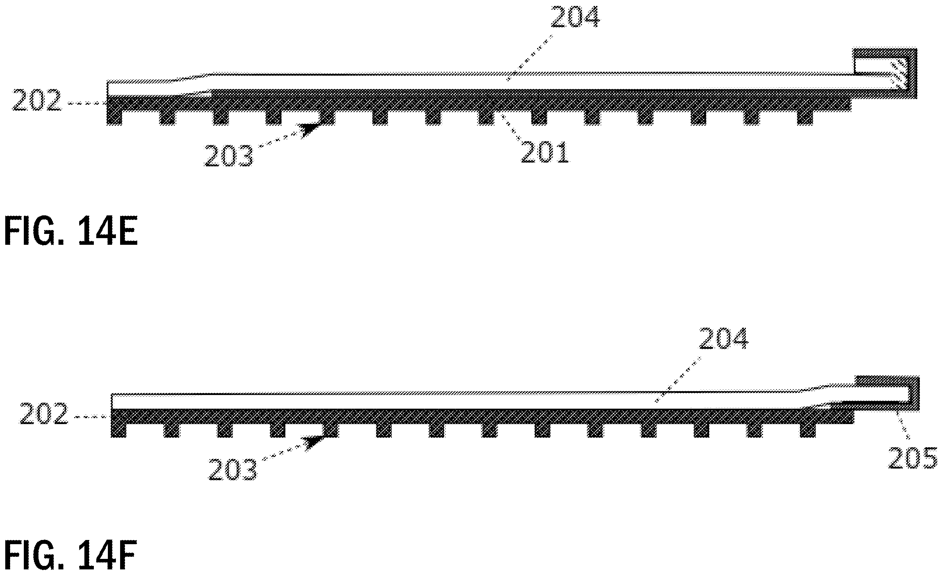

In FIGS. 13A/13B/13C/13D, the electrode layer is depicted as reference 101. Nodules 103, or pillars 103, which are all connected by base layer of the same material, with which base layer of the same material they form a single unit that represents an elastic layer 102. Nevertheless, this is only one example, and in other implementations not being part of the present invention the nodules, or the pillars, may be individually distributed forming the compressive layer without connection between them, or may be connected by a grid structure of the same or a different material. The presented active elements are intended for stacking and driving a charge between adjacent ones in order to generate attraction between them. A critical problem in electrostatic systems, like the ones in present invention, is that, when they are subjected to a relatively high potential difference, electric discharge may occur between the electrode layers. To address this problem, each one of the configurations presented on the different example embodiments must be specifically adapted, when the applied voltage difference is sufficiently high, to prevent the dielectric breakdown of the fluid between the electrodes, as described above. In the current example embodiment, the non-conductive elastic layer 102 has a larger surface area than the electrode layer 101, and this area difference is sufficient to prevent the electric discharge between electrodes if the applied potential difference is low enough. The electrodes may be insulated, in this way, using the same material that forms the elastic nodules and may form part of the same layer, but electrical insulation can also be achieved or improved by covering completely the exposed electrode areas, in contact with the fluid between the electrodes, with the an additional insulating layer made of a highly electrically-insulating material, such as polymer or polyimide, e.g. Kapton, thus forming layers to prevent electrical discharges between two or more electrodes of the active elements. This later configuration is illustrated in the following example embodiment of FIGS. 14A/14B/14C/14D/14E/14F.

FIGS. 14A/14B/14C/14D/14E/14F illustrate an active element according to the present invention. According to the present invention, the electric discharge between electrodes is further prevented by the inclusion of an additional insulating layer. Figures 14A and 14B are top and bottom views of the active element, respectively. Figures 14C and 14D/14E/14F are profile view sections of the active element across the axes AB and CD, FIGS. 14D/14E/14F presenting different alternative configurations, respectively, as depicted in Figure 14B.

In FIGS. 14A/14B/14C/14D/14E/14F, an electrode layer is depicted as reference 201. Nodules 203, or pillars 203, which, together with a base layer of the same material, form an integral part of an elastic layer 202. An insulating layer is illustrated as reference 204, and the surface of said insulating layer 204 extends beyond the edge of the area of the electrode 201, making direct contact with the non-conductive elastic layer 202 in this region for electrical insulation. The position of the electrode 201, between the elastic 202 and insulating 204 layers, is indicated as a thin dotted line in Figures 14A and 14B.

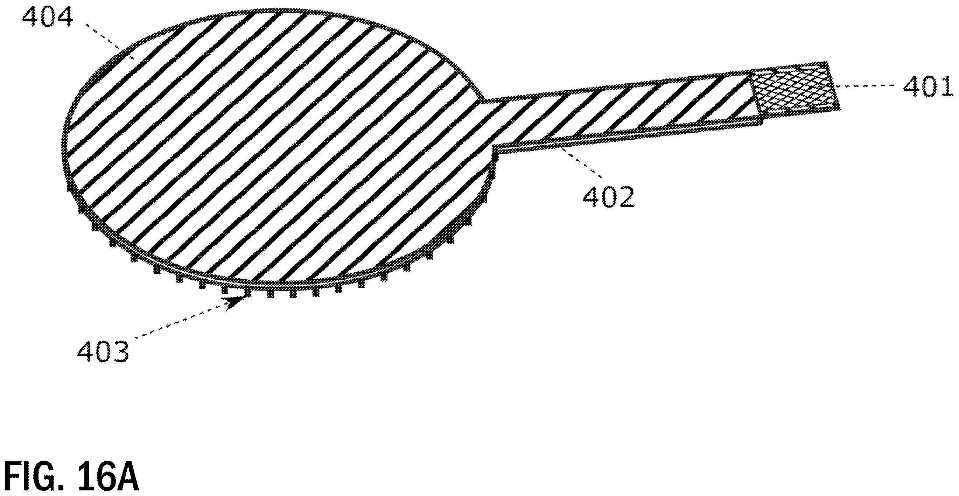

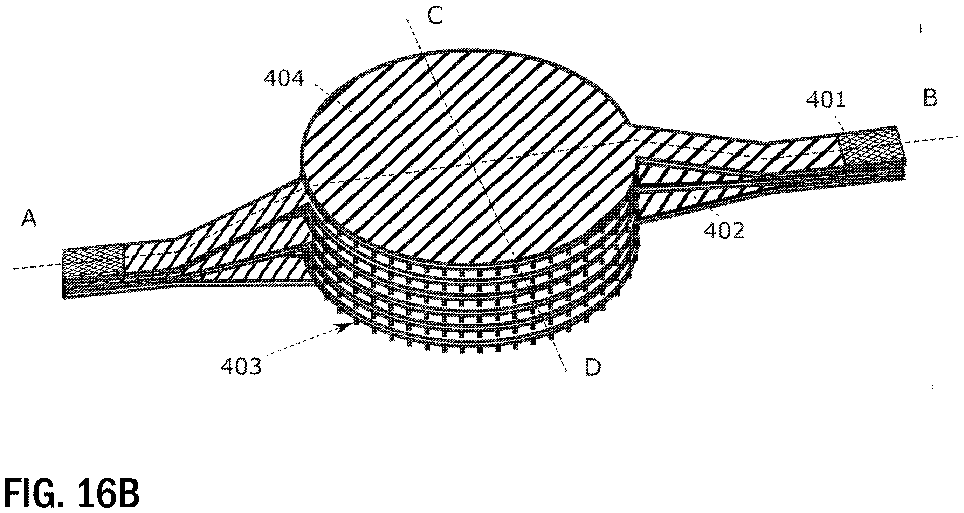

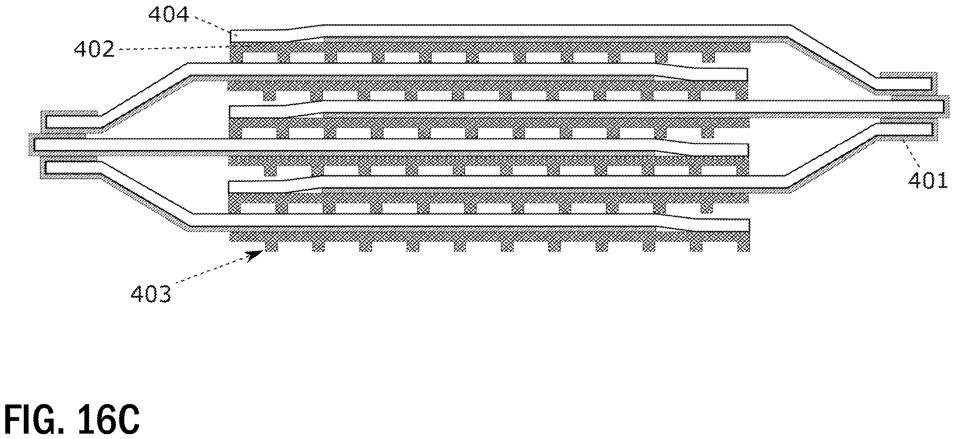

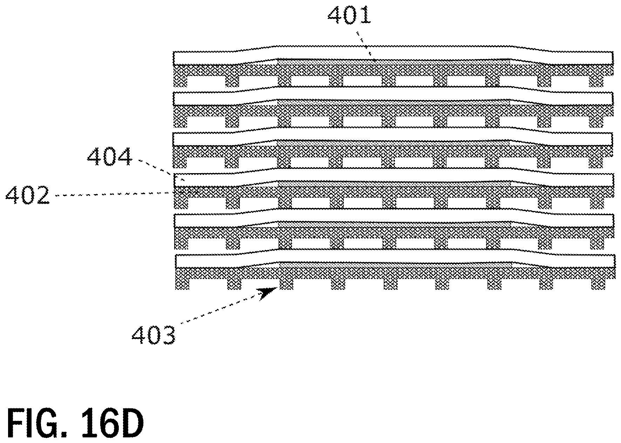

The different alternative configurations of FIGS. 14D/14E/14F represent examples of different alternatives for the structure of the exposed region of the electrode layer 201, which is necessary for electric connection. They all target at allowing the electrical contact from both sides of the active element, which is very useful in some basic stack configurations, as the one illustrated in FIGS. 16A/16B/16C/16D described below.

In Figure 14D, the electrode layer 201, at the electric-contact region, bends after the edge of the insulating layer 204, and extends over its upper side, keeping direct contact with its upper surface. The configuration illustrated in this figure is only possible if the conductivity of the electrode layer is not compromised by its high bending at the edge. For example, a solid metallic layer, like copper foil, is a suitable material for some embodiments.

In Figure 14E, the electrode layer 201 is constantly in contact with the bottom side of the insulating layer 204, and it bends together with it, at the contact region, exposing the electrode from both sides of the active element. Depending on the maximum curvature at the bending edge of these layers, this configuration will allow the use of much thinner electrode layers, like e.g. thin-film coating.

In Figure 14F, an extremely thin electrode layer (not visible in the figure) is constantly in contact with the bottom side of the insulating layer 204. A thicker conductive layer 205 is placed at the contact region, in direct electric contact with the electrode layer at the bottom of the insulating layer 204, and bending after the edge, thus facilitating electric contact from both sides of the active element in this region.

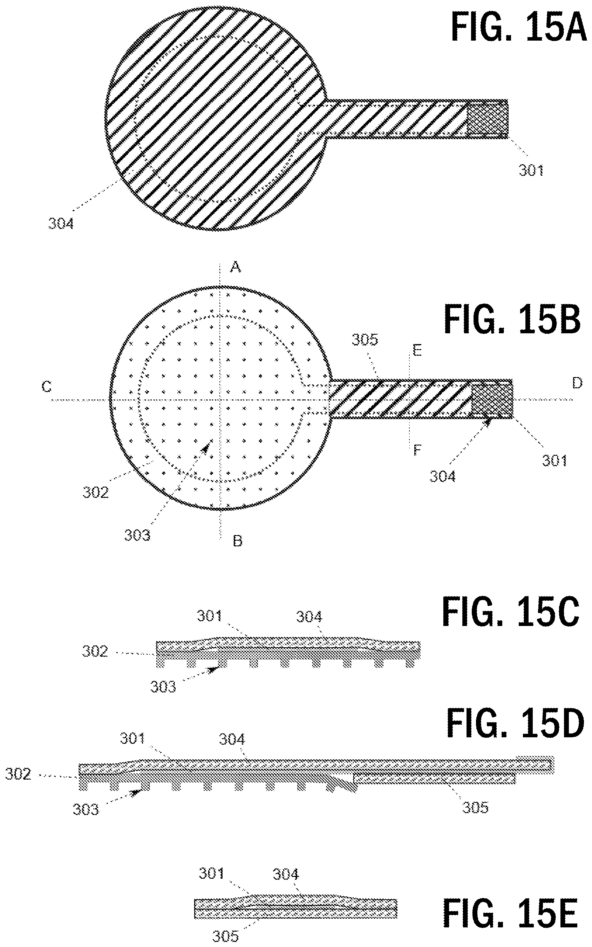

FIGS. 15A/15B/15C/15D/15E illustrate an active element according to a third example embodiment of the present invention. In presented another example embodiment of FIGS. 15A/15B/15C/15D/15E, the electric discharge between electrodes is further prevented by the inclusion of a second additional insulating layer 305. Figures 15A and 15B are top and bottom views of the active element, respectively. Figures 15C, 15D, and 15E are profile view sections of the active element across the axes AB, CD, and EF, respectively, as depicted in Figure 15B.

In FIGS. 15A/15B/15C/15D/15E, an electrode layer is depicted as reference 301. Nodules 303, or pillars 303, which, together with a base layer of the same material, form an integral part of an elastic layer 302. A first insulating layer 304, and its surface extends beyond the edge of the area of the electrode 301, making direct contact with the non-conductive elastic layer 302, or with an additional insulating layer 305 in the extended contact region, for electrical insulation. The position of the electrode 301, between the elastic layer 302 (or insulating layer 305) and insulating 304 layers, is indicated as a thin dotted line in Figures 15A and 15B.

The main difference between the examples in FIGS. 14A/14B/14C/14D/14E/14F and FIGS. 15A/15B/15C/15D/15E is that the part of the non-conductive elastic layer 202 that extended along the narrow straight area towards the contact region in FIGS. 14A/14B/14C/14D/14E/14F has been replaced by a second insulating layer 305 in FIGS. 15A/15B/15C/15D/15E. This can be beneficial for simpler, or more economical, manufacturing, or for a more robust final product. It can also help to restrict the moving or bending of the electrode layer in this connecting region.

FIGS. 16A/16B/16C/16D illustrate an active element stack according to an example embodiment of the present invention. Figures 16A and 16B are perspective views of a basic active element composing the active element stack, and of one possible configuration of the final active element stack, respectively. Figures 16C and 16D are profile view sections of the active element stack across the axes AB and CD, respectively, as depicted in Figure 16B. In FIGS. 16A/16B/16C/16D, the electrode layers are presented as elements 401, the elastic layers are presented as elements 402, including their corresponding pillars 403, and the insulating layers are presented as elements 404.

In FIGS. 16A/16B/16C/16D, the contact points for electrical connection are positioned in a 180 deg configuration (following a straight line), but, depending of the final arrangement of the sensor or of the actuator (sensors/actuators), they can be placed forming any other angle, as soon as they do not overlap between them.

The electric contact between the electrodes 401 at each side of the active element stack can be made by soldering them together, or by using some mechanical clamping, like e.g. an alligator clip, or by clamping them between small permanent magnets. The robustness and safety of the electric connection can be increased by sealing it with solid material (like e.g. the one in the elastic layer).

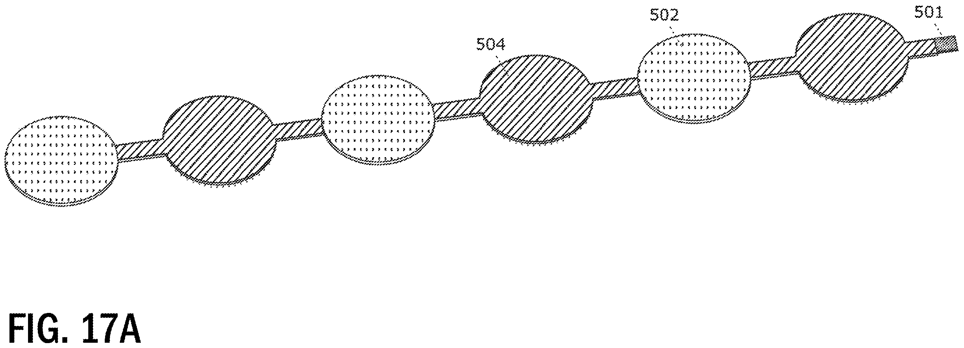

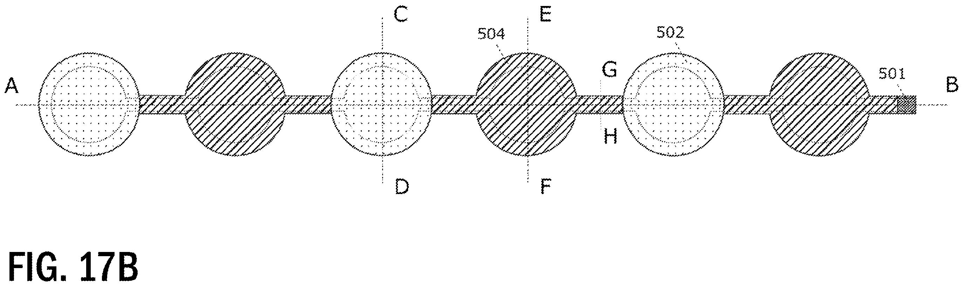

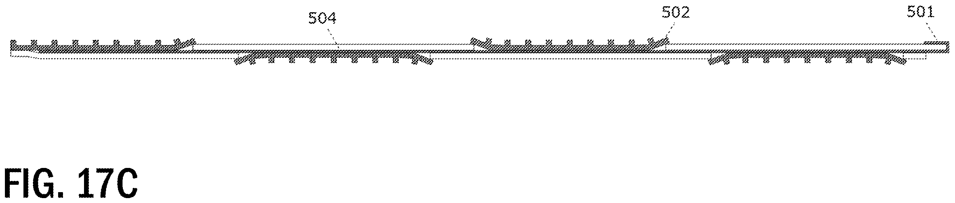

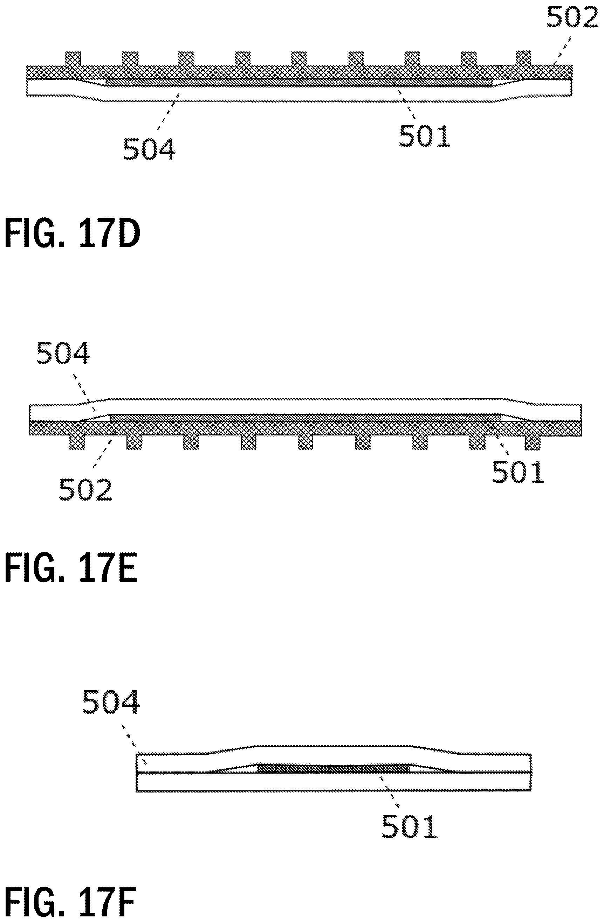

FIGS. 17A/17B/17C/17D/17E/17F illustrate a basic active element composing the active element stack according to another example embodiment of the present invention. Figures 17A and 17B are perspective and top views of this new active element, respectively. Figures 17C, 17D, 17E and 17F are profile view sections of the active element across the axes AB, CD, EF, and GH, respectively, as depicted in Figure 17B. In FIGS. 17A/17B/17C/17D/17E/17F, the electrode layer is depicted as reference 501, the elastic layers (including the pillars) as references 502, and the insulating layers as references 504. The position of the electrode layer 501, between the elastic layer 502 and insulating 504 layers (or between insulating layers 504 of Figure 17F), is indicated as a thin dotted line in Figure 17B.

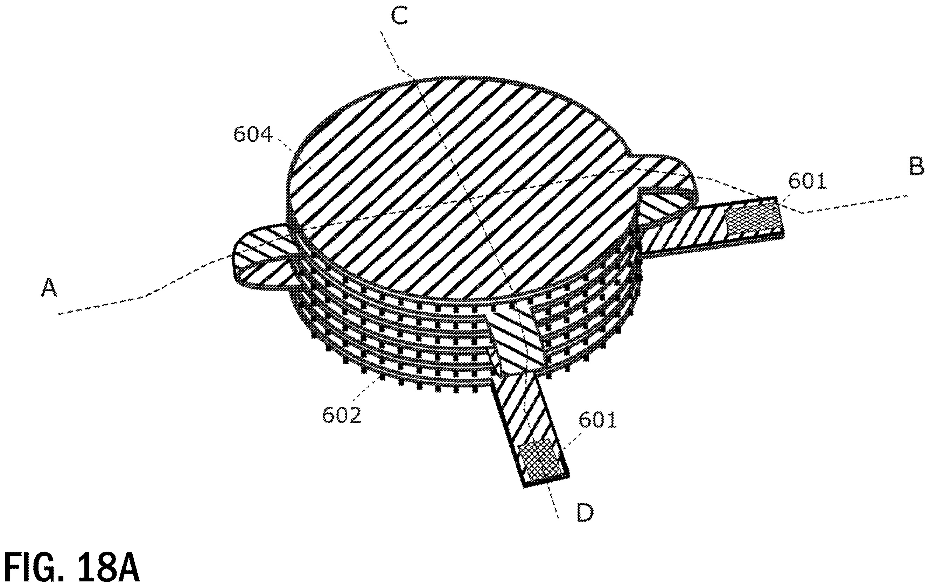

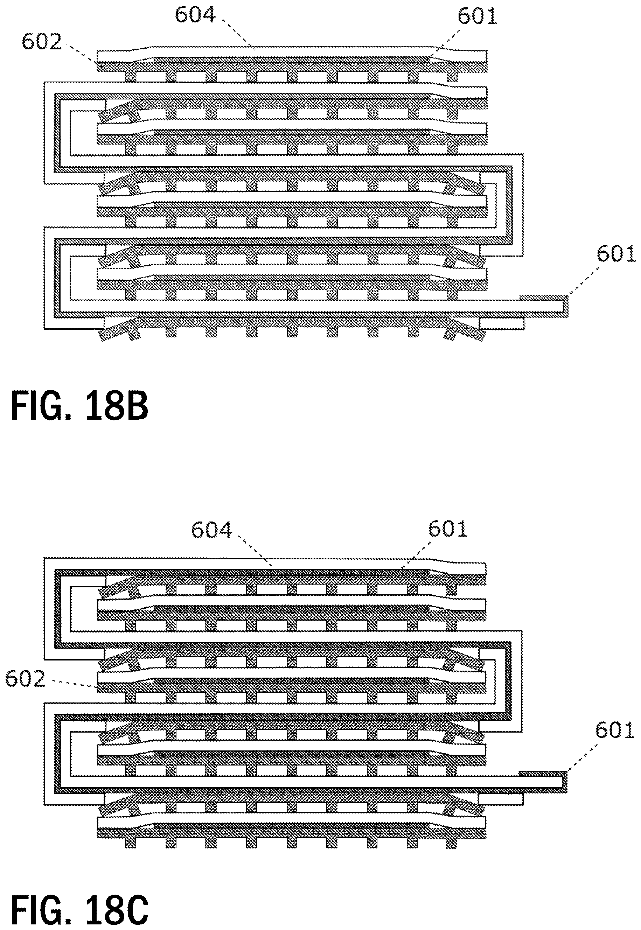

FIGS. 18A/18B/18C illustrate a possible staking configuration for the active elements described in the former example embodiment of the present invention. In these figures, the basic active elements described in FIGS. 17A/17B/17C/17D/17E/17F are stacked in a configuration, where only two basic active elements are overlapped in an interlaced configuration. Figure 18A represent a perspective view of a possible stacking configuration of the basic active elements described in FIGS. 17A/17B/17C/17D/17E/17F, and Figures 18B and 18C are profile view sections of the stack across the axes AB and CD, respectively, as depicted in Figure 18A. In FIGS. 18A/18B/18C, the electrode layers are presented as references 601, the elastic layers are presented as references 602 (including their corresponding pillars), and the insulating layers are presented as references 604.

As commented above, the number of basic active elements (like the ones in FIGS. 17A/17B/17C/17D/17E/17F) per stack, in this example embodiment of the present invention, is two. However, as can be seen in FIGS. 18A/18B/18C, the number of active layers, which is equivalent to the number of elastic layers (502 or 602), is determined by the length of the basic active element, i.e. by the number of elastic layers that it incorporates.

The main advantages of the stack of active elements described in FIGS. 18A/18B/18C, with respect to the one described in FIGS. 16B/16C/16D, are the presence of a single contact point for electrical connection, per electrode layer, and a higher stack robustness. In addition, the length of the active element described in FIGS. 17A/17B/17C/17D/17E/17F can be adjusted by simply cutting a longer stripe roll at a specific length. However, this option requires that a new contact point for electrical connection will be available after cutting, which e.g. can be achieved by letting exposed part of the electrode layer 501 in the areas between the elastic layers 502.

Both types of active elements, the ones in Figures 13A to 16D, or the ones in Figures 17A to 18C, can be manufactured following existing industrial processes, like injection molding, roll to roll laminations, and cutting stages.

A stack of active elements can work as a single actuation element, or several stacks (from each configuration - FIGS. 16A/16B/16C/16D and 18A/18B/18C - or incorporating a mixture of both) can be connected in parallel to a same electric signal source. The horizontal distribution of multiple stacks, as described above, may facilitate the production of different actuation in different localized areas.

The source can provide the signal to each stack by e.g. connecting them to a conductive mesh, or grid, of cables or laminated conductors, or to a printed circuit board, or to any other configuration.

For all the layers that appear in direct contact with each other in all the figures, it can be assumed that it is possible that they may include a small layer of adhesive connecting them to increase robustness of the active element.

Due to the absence of variation in the surface area of the active element upon compression, which is the main advantage of the pillar-based elastic layer with respect to classical electroactive polymer actuators, the material of the electrode layer can be freely chosen among any convenient conductive or semiconductive materials, and the value of the resistivity of the electrode is expected to remain constant during the compression of the stack due to the absence of stretching in this layer.

The material of the elastic layer can be any non-conductive elastic material, like natural rubber, polymer such as e.g. Polydimethylsiloxane (PDMS) or composite material.

Depending on the final application, the surface area of an active element can range from 1 mm² to 100 m², or more.

The surface shape of an active element is not defined. active elements can be circular, hexagonal, squared, triangular, or can have any other shapes, like any complex polygonal shape. For the sake of clarity, only circular shapes appear in the examples presented.

An active element, as a layer, is partially bendable, so that a stack of them can be accommodated to provide actuation, sensing, or both, over surfaces with a moderate curvature.

The minimum amount of individual active elements to produce a functional stack is two. There is not a defined maximum number of active elements to produce a functional device; Depending on the application, they can range from 2 to 1000, or more.

The shape of the pillars can be cylindrical, cubical, or can have more complex structures, like truncated cones, or other.

The stacks of active elements presented in FIGS. 16A/16B/16C/16D and 18A/18B/18C may include an additional bottom layer without elastic layer (just electrode and insulating layer), for those cases where the presence of the bottom layer of the stack being compressible, or presenting pillar structures, will be inconvenient.

The stacks of active elements presented in FIGS. 16A/16B/16C/16D and 18A/18B/18C may be contained in a bag, pouch, or envelope of insulating material to increase the safety and durability of the final product, and to protect it from potential problems induced by environmental humidity.

In an alternative embodiment, said two or more electrostatic actuation layers of said electrostatic actuator structure comprise several electrostatic actuation layers stacked one above the other so that similar structural elements of said layers do not coincide even partially, i.e. imbricatedly stacked one above the other. In said alternative embodiment, a possible bending caused by the force in one electrostatic actuation layer aligns in the vicinity of one or more of elastic supports of another electrostatic actuation layer/layers. This leads to an overall structure wherein the stack of the electrostatic actuation layers according to said alternative embodiment compresses approximately uniformly despite the bending occurring in individual layer of the said structure. Bending in this context refers here to a process where in the electrostatic actuation layers become curved so that the areas between the elastic support nodules come closer to the opposite electrodes than at locations of the elastic support nodules.

In another alternative embodiment, said electrostatic actuator structure comprises a grid of more rigid tile structures and more malleable areas between the more rigid structures. The structure of said another alternative embodiment allows the bending of the actuator surface at sites of the malleable area structures, while retaining local rigidity at sites of the rigid tile structures which said rigid tile structures facilitate compressing while resisting bending between the nodules when the potential difference is applied for the electrostatic actuation layers.

The specific configuration and structure of this invention can provide actuation and sensitive detection in a same system, which is convenient and not common in existing devices.

The specific configuration and structure of this invention can provide actuation and sensitive detection in a same system. As the driving signal is known the change in capacitance and the current drawn by the actuator can be monitored, it is possible to estimate the overall compression of the said actuator. Furthermore, capacitance of the system can be monitored also without driving signal that would notably compress the system. In that case changes in the system capacitance indicate compression of the system by external forces. Various calibration procedures allow to turn the measured signal values into estimates of changes of the physical deformations of the system. The system may also be divided into subsystems with each having its own monitoring circuitry, which allows for more localized monitoring of the physical changes in the system. It is further noted that capacitance changes can be monitored via various other signal proxies such as voltage changes, current draw changes or changes in oscillator frequencies in the system.

The interdigitated configuration of the electrode layers makes the capacitance of the stack very sensitive to small stack compressions. Therefore, functionality for compression sensing can be achieved by the constant monitoring of the capacitance of the stack.

Instead of comprising elastic support nodules, further examples of said electrostatic actuator structures not being part of the present invention may comprise rigid supports, elastic layer materials, foam-filled structures, continuous supports, continuous limiting structures, web structures, bulging supports e.g. attached to a top layer. One further example of said electrostatic actuator structure not being part of the present invention may comprise air on sealed cells, working as spring when compressed. Another further example of said electrostatic actuator structure not being part of the present invention may comprise solid semi-foam working as the spring between electrodes. Here with solid semi-foam means a solid foam where the air packs are not completely sealed, but they polymerize leaving holes in the solid walls between the air bubbles. A third further example of said electrostatic actuator structure not being part of the present invention may comprise a 3D printed, or moulded, 3D grid made from proper polymers working as spring when compressed. In this context, magnets may be utilized so that for higher spring constant values, the repulsion of constrained magnets, placed facing each other with opposite polarity, could be employed as separation nodes.

It is to be understood that the above description and the accompanying Figures are only intended to teach the best way known to the inventors to make and use the invention. It will be apparent to a person skilled in the art that the inventive concept can be implemented in various ways. The above-described embodiments of the invention may thus be modified or varied, without departing from the invention, as appreciated by those skilled in the art in light of the above teachings. It is therefore to be understood that the invention and its embodiments are not limited to the examples described above but may vary within the scope of the appended claims.

## Claims

1. An active element structure comprising at least two stacked active elements, each of said active elements of said at least two stacked active elements comprising:
- a substrate film which comprises a conductive or semiconductive electrode layer (101, 201, 301, 401, 501, 601),
- an elastic layer (102, 202, 302, 402, 502, 602) comprising a multitude of elastic support nodules (103, 203, 303, 403) arranged in a grid array, so that there is arranged a compression space between the active element and its adjacent active element, said compression space having a space gap between said multitude of elastic support nodules (103, 203, 303, 403), said multitude of elastic support nodules (103, 203, 303, 403) forming, together with a base layer of the same material, an integral part of said elastic layer (102, 202, 302, 402, 502, 602), and
- at least one insulating layer (204, 304, 305, 404, 504, 604), said at least one insulating layer (204, 304, 305, 404, 504, 604) covering said conductive or semiconductive electrode layer (101, 201, 301, 401, 501, 601), extending beyond the edge of the area of said conductive or semiconductive electrode layer (101, 201, 301, 401, 501, 601), and making direct contact with said elastic layer (102, 202, 302, 402, 502, 602) in this region for electrical insulation;
- wherein said conductive or semiconductive electrode layer (101, 201, 301, 401, 501, 601) is positioned between said elastic layer (102, 202, 302, 402, 502, 602) and an insulating layer (204, 304, 305, 404, 504, 604) of said at least one insulating layer (204, 304, 305, 404, 504, 604), and
- wherein said active element structure is arranged to compress due to electrostatic attraction between adjacent active elements of said at least two stacked active elements when voltage difference is applied between them.

2. The active element structure of claim 1, wherein each of said active elements of said at least two stacked active elements comprise:
an additional insulating layer of said at least one insulating layer (204, 304, 305, 404, 504, 604), said additional insulating layer being made of a highly electrically-insulating material, and said additional insulating layer covering the exposed electrode areas for improved electrical insulation.

3. The active element structure of claim 1, wherein a distance between said at least two stacked active elements is less than 1000 micrometers (1000 µm), preferably less than 200 micrometers (200 µm).

4. The active element structure of claim 1, wherein the adjacent support nodules (103, 203, 303, 403) of said multitude of elastic support nodules (103, 203, 303, 403) are arranged less than 10 mm distance apart from each other, preferably less than 2 mm distance apart from each other.

5. The active element structure of claim 1, wherein said multitude of elastic support nodules (103, 203, 303, 403) have a height to maximum width aspect ratio with a maximum value of two.

6. The active element structure of claim 1, wherein surfaces of said active conductive or semiconductive electrode layers of said elements are inherently hydrophobic or are hydrophobically or superhydrophobically coated or hydrophobically or superhydrophobically treated.

7. The active element structure of claim 1, wherein said at least two stacked active elements are stacked one above the other.

8. The active element structure of claim 1, wherein said active element structure comprises a grid of more rigid tile structures and more malleable area structures.

9. The active element structure of claim 1, wherein said active element structure is hermetically sealed.

10. The active element structure of claim 1, wherein said active element structure comprises gas reservoirs, e.g. air reservoirs.

11. The active element structure of claim 9, comprising at least two stacks of said at least two stacked active elements, at least one gas reservoir and an elastic surface layer arranged on top of said at least two stacks of active elements and on top of said at least one gas reservoir.

12. The active element structure of claim 1, wherein said active element is flexible.

13. The active element structure of claim 1, wherein said conductive or semiconductive electrode layer (101, 201, 301, 401, 501, 601) is made of material that is semiconductive between 100kOhm/square to 100MOhm/square of surface resistance.

14. The active element structure of claim 1, further comprising means for monitoring its electrical signal properties to allow the detection and/or control of physical changes.

15. An actuator/sensor, comprising an active element structure of any one of claims 1 to 14.

## Patentansprüche

1. Aktiv-Elementaufbau mit mindestens zwei gestapelten Aktiv-Elementen, worin jedes der Aktiv-Elemente der mindestens zwei gestapelten Aktiv-Elemente umfasst:
einen Substratfilm, der eine leitende oder halbleitende Elektrodenschicht (101, 201, 301, 401, 501, 601) umfasst,
eine elastische Schicht (102, 202, 302, 402, 502, 602), die mehrere elastische Stützknoten (103, 203, 303, 403) umfasst, die in einer Gitteranordnung angeordnet sind, so dass ein Kompressionsraum zwischen dem Aktiv-Element und seinem benachbarten Aktiv-Element bereitgestellt ist, worin der Kompressionsraum einen Zwischenraum zwischen den mehreren elastischen Stützknoten (103, 203, 303, 403) aufweist, worin die mehreren elastischen Stützknoten (103, 203, 303, 403) zusammen mit einer Basisschicht aus dem gleichen Material einen Teil der elastischen Schicht (102, 202, 302, 402, 502, 602) einstückig ausbilden, und
mindestens eine Isolationsschicht (204, 304, 305, 404, 504, 604), worin die mindestens eine Isolationsschicht (204, 304, 305, 404, 504, 604) die leitende oder halbleitende Elektrodenschicht (101, 201, 301, 401, 501, 601) bedeckt, die sich über den Rand des Bereichs der leitenden oder halbleitenden Elektrodenschicht (101, 201, 301, 401, 501, 601) hinaus erstreckt und in diesem Bereich zur elektrischen Isolierung direkten Kontakt mit der elastischen Schicht (102, 202, 302, 402, 502, 602) herstellt;
worin die leitende oder halbleitende Elektrodenschicht (101, 201, 301, 401, 501, 601) zwischen der elastischen Schicht (102, 202, 302, 402, 502, 602) und einer isolierenden Schicht (204, 304, 305, 404, 504, 604) der mindestens einen isolierenden Schicht (204, 304, 305, 404, 504, 604) angeordnet ist, und
worin der Aktiv-Elementaufbau angeordnet ist, um aufgrund elektrostatischer Anziehung zwischen benachbarten Aktiv-Elementen der mindestens zwei gestapelten Aktiv-Elemente komprimiert zu werden, wenn eine Spannungsdifferenz zwischen ihnen angelegt wird.

2. Aktiv-Elementaufbau nach Anspruch 1, worin jedes der Aktiv-Elemente der mindestens zwei gestapelten Aktiv-Elemente umfasst:
eine zusätzliche Isolierschicht der mindestens einen Isolierschicht (204, 304, 305. 404, 504, 604), worin die zusätzliche Isolierschicht aus einem hoch elektrisch isolierenden Material gefertigt ist und die zusätzliche Isolierschicht die freiliegenden Elektrodenbereiche für eine verbesserte elektrische Isolierung bedeckt.

3. Aktiv-Elementaufbau nach Anspruch 1, worin ein Abstand zwischen den mindestens zwei gestapelten Aktiv-Elementen weniger als 1000 Mikrometer (1000 µm), vorzugsweise weniger als 200 Mikrometer (200 µm), beträgt.

4. Aktiv-Elementaufbau nach Anspruch 1, worin die benachbarten Stützknoten (103, 203, 303, 403) der mehreren elastischen Stützknoten (103, 203, 303, 403) in einem Abstand von weniger als 10 mm, vorzugsweise weniger als 2 mm, zueinander angeordnet sind.

5. Aktiv-Elementaufbau nach Anspruch 1, worin die mehreren elastischen Stützknoten (103, 203, 303, 403) ein Seitenverhältnis von Höhe zu maximaler Breite mit einem maximalen Wert von zwei aufweisen.

6. Aktiv-Elementaufbau nach Anspruch 1, worin die Oberflächen der aktiven leitenden oder halbleitenden Elektrodenschichten der Elemente inhärent hydrophob sind oder hydrophob oder superhydrophob beschichtet oder hydrophob oder superhydrophob behandelt sind.

7. Aktiv-Elementaufbau nach Anspruch 1, worin die mindestens zwei gestapelten Aktiv-Elemente übereinander gestapelt sind.

8. Aktiv-Elementaufbau nach Anspruch 1, worin der Aktiv-Elementaufbau ein Gitter aus steiferen Kachelstrukturen und formbareren Flächenstrukturen umfasst.

9. Aktiv-Elementaufbau nach Anspruch 1, worin der Aktiv-Elementaufbau hermetisch versiegelt ist.

10. Aktiv-Elementaufbau nach Anspruch 1, worin der Aktiv-Elementaufbau Gasreservoirs, wie z. B. Luftreservoirs, umfasst.

11. Aktiv-Elementaufbau nach Anspruch 9, welcher mindestens zwei Stapel der mindestens zwei gestapelten Aktiv-Elemente, mindestens ein Gasreservoir und eine elastische Oberflächenschicht umfasst, die auf den mindestens zwei Stapeln von Aktiv-Elementen und auf dem mindestens einen Gasreservoir angeordnet ist.

12. Aktiv-Elementaufbau nach Anspruch 1, worin das aktive Element flexibel ist.

13. Aktiv-Elementaufbau nach Anspruch 1, worin die leitende oder halbleitende Elektrodenschicht (101, 201, 301, 401, 501, 601) aus einem Material besteht, das einen Oberflächenwiderstand zwischen 100 kOhm/Quadrat bis 100 MOhm/Quadrat aufweist.

14. Aktiv-Elementaufbau nach Anspruch 1, welcher ferner Mittel zur Überwachung ihrer elektrischen Signaleigenschaften umfasst, um die Erkennung und/oder Steuerung physikalischer Veränderungen zu ermöglichen.

15. Aktor/Sensor, welcher einen Aktiv-Elementaufbau nach einem der Ansprüche 1 bis 14 umfasst.

## Revendications

1. Structure d'éléments actifs comprenant au moins deux éléments actifs empilés, chacun desdits éléments actifs desdits au moins deux éléments actifs empilés comprenant:
un film de substrat, qui comprend une couche d'électrode conductrice ou semi-conductrice (101, 201, 301, 401, 501, 601),
une couche élastique (102, 202, 302, 402, 502, 602) comprenant une multitude de nodules de support élastiques (103, 203, 303, 403) disposés selon un réseau en grille, de sorte qu'il existe un espace de compression entre l'élément actif et son élément actif adjacent, ledit espace de compression ayant un interstice entre ladite multitude de nodules de support élastique (103, 203, 303, 403), ladite multitude de nodules de support élastique (103, 203, 303, 403) formant, avec une couche de base du même matériau, une partie intégrante de ladite couche élastique (102, 202, 302, 402, 502, 602), et
au moins une couche isolante (204, 304, 305, 404, 504, 604), ladite au moins une couche isolante (204, 304, 305, 404, 504, 604) couvrant ladite couche d'électrode conductrice ou semi-conductrice (101, 201, 301, 401, 501, 601), s'étendant au-delà du bord de la zone de ladite couche d'électrode conductrice ou semi-conductrice (101, 201, 301, 401, 501, 601), et établissant un contact direct avec ladite couche élastique (102, 202, 302, 402, 502, 602) dans cette région pour l'isolation électrique;
dans lequel ladite couche d'électrode conductrice ou semi-conductrice (101, 201, 301, 401, 501, 601) est positionnée entre ladite couche élastique (102, 202, 302, 402. 502, 602) et une couche isolante (204, 304, 305, 404, 504, 604) de ladite au moins une couche isolante (204, 304, 305, 404, 504, 604), et
dans lequel ladite structure d'éléments actifs est agencée pour se comprimer en raison de l'attraction électrostatique entre des éléments actifs adjacents desdits au moins deux éléments actifs empilés lorsqu'une différence de tension est appliquée entre eux.

2. Structure d'éléments actifs selon la revendication 1, dans laquelle chacun desdits éléments actifs desdits au moins deux éléments actifs empilés comprend:
une couche isolante supplémentaire de ladite au moins une couche isolante (204, 304, 305. 404, 504, 604), ladite couche isolante supplémentaire étant faite d'un matériau hautement isolant électriquement, et ladite couche isolante supplémentaire couvrant les zones d'électrodes exposées pour une isolation électrique améliorée.

3. Structure d'éléments actifs selon la revendication 1, dans laquelle une distance entre lesdits au moins deux éléments actifs empilés est inférieure à 1000 micromètres (1000 µm), de préférence inférieure à 200 micromètres (200 µm).

4. Structure d'élément actif selon la revendication 1, dans laquelle les nodules de support adjacents (103, 203, 303, 403) de ladite multitude de nodules de support élastiques (103, 203, 303, 403) sont disposés à une distance inférieure à 10 mm les uns des autres, de préférence à une distance inférieure à 2 mm les uns des autres.

5. Structure d'élément actif selon la revendication 1, dans laquelle ladite multitude de nodules de support élastiques (103, 203, 303, 403) a un rapport d'aspect hauteur sur largeur maximale avec une valeur maximale de deux.

6. Structure d'élément actif selon la revendication 1, dans laquelle les surfaces desdites couches d'électrodes actives conductrices ou semi-conductrices desdits éléments sont intrinsèquement hydrophobes ou sont recouvertes d'un revêtement hydrophobe ou superhydrophobe ou traitées de manière hydrophobe ou superhydrophobe.

7. Structure d'éléments actifs selon la revendication 1, dans laquelle lesdits au moins deux éléments actifs empilés sont empilés l'un au-dessus de l'autre.

8. Structure d'élément actif selon la revendication 1, dans laquelle ladite structure d'élément actif comprend une grille de structures de tuiles plus rigides et de structures de zones plus malléables.

9. Structure d'élément actif selon la revendication 1, dans laquelle ladite structure d'élément actif est hermétiquement scellée.

10. Structure d'élément actif selon la revendication 1, dans laquelle ladite structure d'élément actif comprend des réservoirs de gaz, par exemple des réservoirs d'air.

11. Structure d'éléments actifs selon la revendication 9, comprenant au moins deux empilements desdits au moins deux éléments actifs empilés, au moins un réservoir de gaz et une couche de surface élastique disposée sur le dessus desdits au moins deux empilements d'éléments actifs et sur le dessus dudit au moins un réservoir de gaz.

12. Structure d'éléments actifs selon la revendication 1, dans laquelle ledit élément actif est flexible.

13. Structure d'élément actif selon la revendication 1, dans laquelle ladite couche d'électrode conductrice ou semi-conductrice (101, 201, 301, 401, 501, 601) est faite d'un matériau qui est semi-conducteur entre 100 kOhm/carré à 100 MOhm/carré de résistance de surface.

14. Structure d'élément actif selon la revendication 1, comprenant en outre des moyens pour surveiller ses propriétés de signal électrique afin de permettre la détection et/ou le contrôle de changements physiques.

15. Actionneur/capteur, comprenant une structure d'élément actif de l'une quelconque des revendications 1 à 14.
